# EUROPEAN PATENT APPLICATION

(11) **EP 4 842 175 A1**
(43) Date of publication of application: **18.11.2026**
(21) Application number: 26167845.2
(22) Date of filing: 25.03.2026
(51) Int. Cl.: H10K 59/122, H10K 59/131, H10K 59/80, H10K 59/38

(54) **DISPLAY APPARATUS, ELECTRONIC APPARATUS INCLUDING THE SAME, AND METHOD OF MANUFACTURING THE DISPLAY APPARATUS**

(30) Priority: 13.05.2025 KR 20250062141
(71) Applicant: Samsung Display Co., Ltd., Yongin-si, Gyeonggi-do 17113 (KR)
(72) Inventor: KIM, Seulki, Yongin-si, 17113 (KR); KIM, Yujin, Yongin-si, 17113 (KR); KIM, Jeonghwan, Yongin-si, 17113 (KR); AHN, Ilbae, Yongin-si, 17113 (KR); LEE, Seohee, Yongin-si, 17113 (KR); JUNG, Dohyun, Yongin-si, 17113 (KR)
(74) Representative: Marks & Clerk LLP

(57) **Abstract**

A display apparatus includes a substrate including a display area and a non-display area around (e.g., surrounding) the display area, a first pixel circuit on the display area of the substrate, a first main pixel electrode on the first pixel circuit and electrically connected to the first pixel circuit, a first bank layer covering an end of the first main pixel electrode and having a first opening overlapping a portion of the first main pixel electrode, a first auxiliary pixel electrode on the first bank layer and the first main pixel electrode, an intermediate layer on the first auxiliary pixel electrode, and an opposite electrode on the intermediate layer.

## Description

### BACKGROUND

### 1. Field

One or more embodiments of the present disclosure relate to a display apparatus, an electronic apparatus including the display apparatus, and a method of manufacturing the display apparatus.

### 2. Description of the Related Art

The uses of display apparatuses and electronic apparatuses including the display apparatuses have been diversified. As these applications expand (e.g., the range of uses of the display apparatuses expands), demand for high-resolution display apparatuses has grown. Producing (e.g., manufacturing), such high-resolution display apparatuses, requires arranging electronic elements with appropriate (e.g., one or more suitable) configurations within compact spaces (e.g., in a small and/or narrow area).

### SUMMARY

One or more aspects of embodiments of the present disclosure are directed toward a display apparatus that has improved display quality and luminous efficiency, an electronic apparatus including the display apparatus, and a method of manufacturing the display apparatus. Embodiments set forth herein are examples, and the scope of the disclosure is not limited thereby.

Additional aspects will be set forth in part in the description which follows and, in part, will be apparent from the description, or may be learned by practice of the presented embodiments of the disclosure.

According to one or more embodiments of the present disclosure, a display apparatus includes a substrate including a display area and a non-display area around (e.g., surrounding) the display area, a first pixel circuit on (e.g., arranged on) the display area of the substrate, a first main pixel electrode on (e.g., arranged on) the first pixel circuit and electrically connected to the first pixel circuit, a first bank layer covering an end of the first main pixel electrode and having a first opening overlapping a portion of the first main pixel electrode, a first auxiliary pixel electrode on (e.g., arranged on) the first bank layer and the first main pixel electrode, an intermediate layer on (e.g., arranged on) the first auxiliary pixel electrode, and an opposite electrode on (e.g., arranged on) the intermediate layer.

The first main pixel electrode may include a first sub-layer including a transparent conductive oxide (TCO), a second sub-layer on (e.g., arranged on) the first sub-layer and including at least one selected from the group consisting of silver (Ag), aluminium (Al), magnesium (Mg), lithium (Li), calcium (Ca), copper (Cu), lithium fluoride/calcium (LiF/Ca), lithium fluoride/aluminium (LiF/Al), MgAg, and CaAg, and a third sub-layer on (e.g., arranged on) the second sub-layer and including a transparent conductive oxide (TCO).

The first auxiliary pixel electrode may include a first auxiliary layer including a TCO, and a second auxiliary layer on (e.g., arranged on) the first auxiliary layer and including a TCO.

The first auxiliary layer and the second auxiliary layer may each have a thickness of about 100 angstroms (Å) to about 500 Å.

In one or more embodiments, the display apparatus may further include a second main pixel electrode arranged on a same layer as the first main pixel electrode and spaced and/or apart (e.g., spaced apart or separated) from the first main pixel electrode, wherein the first bank layer may cover an end of the second main pixel electrode and further have a second opening overlapping a portion of the second main pixel electrode, and the intermediate layer may be in direct contact with the second main pixel electrode within the second opening.

In one or more embodiments, the display apparatus may further include a first color conversion portion on (e.g., arranged on) the opposite electrode and overlapping the first opening in a plan view, and a second color conversion portion on (e.g., arranged on) the opposite electrode and overlapping the second opening in a plan view, wherein the first color conversion portion may be configured to convert light emitted from the intermediate layer into light of a first color, and the second color conversion portion may be configured to convert the light emitted from the intermediate layer into light of a second color.

In one or more embodiments, the display apparatus may further include a third main pixel electrode on (e.g., arranged on) a same layer as the first main pixel electrode and spaced and/or apart (e.g., spaced apart or separated) from the first main pixel electrode, and a second auxiliary pixel electrode on (e.g., arranged on) the first bank layer and the third main pixel electrode, whether the first bank layer may cover an end of the third main pixel electrode and further have a third opening overlapping a portion of the third main pixel electrode, and relative to a thickness direction of the substrate, a thickness of the first auxiliary pixel electrode may be greater than a thickness of the second auxiliary pixel electrode.

In one or more embodiments, the display apparatus may further include a first color conversion portion on (e.g., arranged on) the opposite electrode and overlapping the first opening in a plan view, and a transmissive portion on (e.g., arranged on) the opposite electrode and overlapping the third opening in a plan view, wherein the first color conversion portion may be configured to convert light emitted from the intermediate layer into light of a first color, and the transmissive portion may be configured to directly transmit the light emitted from the intermediate layer.

In one or more embodiments, the display apparatus may further include a second bank layer on (e.g., arranged on) the first auxiliary pixel electrode and the first bank layer and arranged below the intermediate layer, wherein the second bank layer may cover an end of the first auxiliary pixel electrode.

A lower surface of the second bank layer may protrude further toward the first opening than an upper surface of the first bank layer.

In one or more embodiments, the display apparatus may further include a pad electrode on (e.g., arranged on) the non-display area of the substrate, and a pad auxiliary layer on (e.g., arranged on) the pad electrode, wherein the pad auxiliary layer may include a same material as at least some selected from among sub-layers included in the first auxiliary pixel electrode.

According to one or more embodiments of the present disclosure, a display apparatus includes a substrate including a display area and a non-display area around (e.g., surrounding) the display area, a circuit layer including a first pixel circuit, a second pixel circuit, and a third pixel circuit that are on (e.g., arranged on) the display area of the substrate, and a display element layer on (e.g., arranged on) the circuit layer and including a first light-emitting diode electrically connected to the first pixel circuit, a second light-emitting diode electrically connected to the second pixel circuit, and a third light-emitting diode electrically connected to the third pixel circuit, wherein the display element layer may further include a first bank layer defining an emission area of each of the first light-emitting diode, the second light-emitting diode, and the third light-emitting diode, each of the first light-emitting diode, the second light-emitting diode, and the third light-emitting diode may include a pixel electrode, an intermediate layer on (e.g., arranged on) the pixel electrode, and an opposite electrode on (e.g., arranged on) the intermediate layer, and relative to a thickness direction of the substrate, a thickness of the pixel electrode of the first light-emitting diode, a thickness of the pixel electrode of the second light-emitting diode, and a thickness of the pixel electrode of the third light-emitting diode may be different from one another.

The pixel electrode of the first light-emitting diode may include a first main pixel electrode and a first auxiliary pixel electrode on (e.g., arranged on) the first bank layer, the pixel electrode of the second light-emitting diode may include a second main pixel electrode that is in direct contact with the intermediate layer, the pixel electrode of the third light-emitting diode may include a third main pixel electrode and a second auxiliary pixel electrode on (e.g., arranged on) the first bank layer, and a thickness of the first auxiliary pixel electrode and a thickness of the second auxiliary pixel electrode may be different from each other in the thickness direction of the substrate.

The first auxiliary pixel electrode may include a first auxiliary layer and a second auxiliary layer on (e.g., arranged on) the first auxiliary layer, and the second auxiliary pixel electrode may include a third auxiliary layer including a same material as the second auxiliary layer.

The first auxiliary layer, the second auxiliary layer, and the third auxiliary layer may each include a TCO material (e.g., a TCO).

In one or more embodiments, the display element layer may further include a second bank layer between (e.g., arranged between) the first bank layer and the intermediate layer, wherein the second bank layer may cover an end of the first auxiliary pixel electrode and an end of the second auxiliary pixel electrode.

In one or more embodiments, the display apparatus may further include a functional layer on (e.g., arranged on) the display element layer, wherein the functional layer may include a first color conversion portion overlapping the first light-emitting diode in a plan view and configured to convert light emitted from the first light-emitting diode into light of a first color, a second color conversion portion overlapping the second light-emitting diode in a plan view and configured to convert light emitted from the second light-emitting diode into light of a second color, and a transmissive portion overlapping the third light-emitting diode in a plan view and configured to directly transmit light emitted from the third light-emitting diode.

According to one or more embodiments of the present disclosure, a method of manufacturing a display apparatus includes: forming, on a substrate, a circuit layer including a first pixel circuit, a second pixel circuit, and a third pixel circuit; forming a planarization layer covering the first pixel circuit, the second pixel circuit, and the third pixel circuit; forming, on the planarization layer, a plurality of main pixel electrodes including a first main pixel electrode electrically connected to the first pixel circuit, a second main pixel electrode electrically connected to the second pixel circuit, and a third main pixel electrode electrically connected to the third pixel circuit; forming a first bank layer arranged on the planarization layer, covering an end of each of the plurality of main pixel electrodes, and including a plurality of openings exposing an upper surface of each of the plurality of main pixel electrodes; forming a plurality of auxiliary pixel electrodes arranged on the first bank layer and including a first auxiliary pixel electrode arranged on the first main pixel electrode and a second auxiliary pixel electrode arranged on the third main pixel electrode; forming an intermediate layer on the first bank layer and the plurality of auxiliary pixel electrodes (e.g., on the first bank layer and the plurality of main pixel electrodes); and forming an opposite electrode on the intermediate layer.

The forming of the plurality of auxiliary pixel electrodes may include forming a first auxiliary layer of the first auxiliary pixel electrode arranged on the first main pixel electrode, and forming a second auxiliary layer of the first auxiliary pixel electrode arranged on the first auxiliary layer, and a third auxiliary layer of the second auxiliary pixel electrode arranged on the third main pixel electrode.

The forming of the first auxiliary layer of the first auxiliary pixel electrode may include: depositing, on an entire surface of the substrate, a first preliminary auxiliary layer arranged on the plurality of main pixel electrodes and the first bank layer; forming, on the first preliminary auxiliary layer, a photoresist overlapping the first main pixel electrode in a plan view; etching a portion of the first preliminary auxiliary layer that does not overlap the photoresist; and stripping the photoresist.

The etching of the portion of the first preliminary auxiliary layer may be performed through a wet etch process, and the plurality of main pixel electrodes may not be etched through the wet etch process.

The forming of the first bank layer may further include hardening the first bank layer through a curing process, wherein a material included in the first preliminary auxiliary layer, and a material included in each of the plurality of main pixel electrodes after the curing process may have different etching selectivities.

The forming of the second auxiliary layer of the first auxiliary pixel electrode and the third auxiliary layer of the second auxiliary pixel electrode may include: depositing, on an entire surface of the substrate, a second preliminary auxiliary layer arranged on the first auxiliary layer; forming, on the second preliminary auxiliary layer, a photoresist overlapping the first main pixel electrode and the third main pixel electrode in a plan view; etching a portion of the second preliminary auxiliary layer that does not overlap the photoresist; and stripping the photoresist.

The etching of the portion of the second preliminary auxiliary layer may be performed through a wet etch process, and the plurality of main pixel electrodes may not be etched through the wet etch process.

In one or more embodiments, the method may further include forming a second bank layer arranged between the first bank layer and the intermediate layer and covering an end of each of the plurality of auxiliary pixel electrodes.

In one or more embodiments, the method may further include forming a functional layer on the opposite electrode, wherein the forming of the functional layer may include forming a first color conversion portion overlapping the first main pixel electrode in a plan view and configured to convert light emitted from the intermediate layer into light of a first color, forming a second color conversion portion overlapping the second main pixel electrode in a plan view and configured to convert light emitted from the intermediate layer into light of a second color, and forming a transmissive portion overlapping the third main pixel electrode in a plan view and configured to directly transmit light emitted from the intermediate layer.

According to one or more embodiments of the present disclosure, an electronic apparatus includes a processor and a display apparatus controlled or selected by the processor, wherein the display apparatus includes a substrate including a display area and a non-display area around (e.g., surrounding) the display area, a circuit layer including a first pixel circuit, a second pixel circuit, and a third pixel circuit that are on (e.g., arranged on) the display area of the substrate, and a display element layer on (e.g., arranged on) the circuit layer and including a first light-emitting diode electrically connected to the first pixel circuit, a second light-emitting diode electrically connected to the second pixel circuit, and a third light-emitting diode electrically connected to the third pixel circuit, wherein the display element layer further includes a first bank layer defining an emission area of each of the first light-emitting diode, the second light-emitting diode, and the third light-emitting diode, each of the first light-emitting diode, the second light-emitting diode, and the third light-emitting diode includes a pixel electrode, an intermediate layer on (e.g., arranged on) the pixel electrode, and an opposite electrode on (e.g., arranged on) the intermediate layer, and relative to a thickness direction of the substrate, a thickness of the pixel electrode of the first light-emitting diode, a thickness of the pixel electrode of the second light-emitting diode, and a thickness of the pixel electrode of the third light-emitting diode are different from one another.

At least some of the above and other features of the invention are set out in the claims.

For example, one or more embodiments of the present disclosure provide a display apparatus and associated manufacturing method that achieve improved optical performance and reliability by controlling resonance distance through pixel electrode thickness variation rather than emission layer thickness, thereby enabling high-resolution displays without reliance on fine metal masks. The disclosed structures-including main and auxiliary pixel electrodes, multi-layer bank configurations, and optional color conversion or transmissive portions-collectively address challenges of light extraction efficiency, color purity, and process scalability. These features, individually and in combination, offer flexibility for integration into various electronic apparatuses while maintaining compatibility with existing fabrication processes.

### BRIEF DESCRIPTION OF DRAWINGS

The accompanying drawings are included to provide a further understanding of the present disclosure and are incorporated in and constitute a part of the present disclosure. The drawings illustrate embodiments of the present disclosure and, together with the description, serve to explain principles of the present disclosure. The above and other aspects, features, and advantages of certain embodiments of the disclosure will be more apparent from the following description taken in conjunction with the accompanying drawings, in which:
FIG. 1 is a schematic perspective view of a display apparatus according to one or more embodiments of the present disclosure;
FIG. 2 is a schematic cross-sectional view of a display apparatus according to one or more embodiments of the present disclosure;
FIG. 3 is a schematic conceptual diagram of a functional layer of a display apparatus according to one or more embodiments of the present disclosure;
FIG. 4 is an equivalent circuit diagram showing a light-emitting diode and a pixel circuit electrically connected to the light-emitting diode, which are included in a display apparatus, according to one or more embodiments of the present disclosure;
FIG. 5 is a schematic cross-sectional view of a portion of a display apparatus according to one or more embodiments of the present disclosure;
FIG. 6 is an enlarged cross-sectional view of a portion of a display apparatus according to one or more embodiments of the present disclosure;
FIGS. 7A - 7J are cross-sectional views schematically showing a process of manufacturing a display apparatus according to one or more embodiments of the present disclosure;
FIG. 8A is a schematic cross-sectional view of a portion of a display apparatus according to one or more embodiments of the present disclosure;
FIG. 8B is a schematic cross-sectional view of a portion of a display apparatus according to one or more embodiments of the present disclosure;
FIG. 9 is a schematic plan view of a display apparatus according to one or more embodiments of the present disclosure;
FIG. 10 is a cross-sectional view of the display apparatus taken along the line A-A' in FIG. 9 according to one or more embodiments of the present disclosure;
FIG. 11 is a block diagram of an electronic apparatus according to one or more embodiments of the present disclosure; and
FIG. 12 is a schematic diagram illustrating various electronic apparatuses according to one or more embodiments of the present disclosure.

### DETAILED DESCRIPTION

Reference will now be made in more detail to one or more embodiments, examples of which are illustrated in the accompanying drawings, wherein like reference numerals refer to like elements throughout, and duplicative descriptions thereof may not be provided for conciseness. In this regard, the presented embodiments may have different forms and should not be construed as being limited to the descriptions set forth herein. Accordingly, one or more embodiments are merely described in more detail, by referring to the drawings, to explain aspects of the present disclosure. As used herein, the term "and/or" or "or" may include any and all combinations of one or more of the associated listed items. Throughout the disclosure, the expressions such as "at least one of," "one of," and "selected from," when preceding a list of elements, modify the entire list of elements and do not modify the individual elements of the list. For example, "at least one of a, b, or c," "at least one selected from a, b, and c," "at least one selected from among a to c," etc., may indicates only a, only b, only c, both (e.g., simultaneously) a and b, both (e.g., simultaneously) a and c, both (e.g., simultaneously) b and c, all of a, b, and c, or variations thereof.

The disclosure is subject to one or more suitable modifications and may have many embodiments, certain of which are illustrated in the drawings and further described in the detailed description. The effects and features of the disclosure, and methods of achieving them will become clear with reference to the embodiments described herein in more detail together with the drawings. However, the disclosure is not limited to the embodiments described herein and may be implemented in one or more suitable forms.

Hereinafter, embodiments will be described in more detail with reference to the accompanying drawings, and if (e.g., when) being described with reference to the drawings, the same or corresponding components are given the same reference numerals/characters, and duplicate descriptions thereof may not be provided for conciseness.

In the present disclosure, the terms "first," "second," and/or the like are not intended to be limiting, and are used only to distinguish one component from another. Thus, a first element described could also be termed as a second or third element without departing from the scope of the disclosure.

In the present disclosure, the singular expression includes the plural unless the context clearly indicates otherwise. For example, the singular forms "a," "an," "one," and "the" as used herein are intended to include the plural forms as well unless the context clearly indicates otherwise

In the present disclosure, the terms "comprise(s)/comprising," "include(s)/including," "has/have/having,", and/or the like are intended to specify the presence of the recited features or components and do not preclude the possibility of the addition of one or more other features or components. Additionally, the terms "comprise(s)/comprising," "include(s)/including," "have/has/having," or other similar terms include or support the terms "consisting of" and "consisting essentially of," indicating the presence of stated features, integers, steps, operations, elements, and/or components, without or essentially without the presence of other features, integers, steps, operations, elements, components, and/or groups thereof. Further, the use of "may" when describing embodiments of the present disclosure refers to "one or more embodiments of the present disclosure.

In the present disclosure, if (e.g., when) a portion of a film, area, component, and/or the like is referred to be over or on top of another portion, this includes not only that it is directly on top of the other portion, but also that there are one or more other films, areas, components, and/or the like arranged therebetween. In contrast, if (e.g., when) an element is referred to as being "directly on" another element, there are no intervening element present therebetween.

In the drawings, components may be exaggerated or reduced in size for ease of illustration. For example, the size and thickness of each configuration shown in the drawings are only for purposes of illustration, and the disclosure is not necessarily limited to those shown.

In one or more embodiments, a particular sequence of processes may be performed in a different order than that described. For example, two processes described in succession may be performed substantially concurrently (e.g., simultaneously), or may be performed in the opposite order from the order described.

In the present disclosure, if (e.g., when) layers, regions, or components are referred to be connected to each other, the layers, the regions, or the components may be directly connected to each other, or another layer, another region, or another component may be interposed between the layers, the regions, or the components, and thus the layers, the regions, or the components may be indirectly connected to each other. For example, in one or more embodiments, if (e.g., when) layers, regions, or components are referred to be electrically connected to each other, the layers, the regions, or the components may be directly electrically connected to each other, or another layer, another region, or another component may be interposed between the layers, the regions, or the components, and thus the layers, the regions, or the components may be indirectly electrically connected to each other.

In the present disclosure, the terms x-axis, y-axis, and z-axis are not limited to three axes in a Cartesian coordinate system, but may be interpreted in a broad sense. For example, the x-axis, y-axis, and z-axis may be orthogonal to each other, or may refer to different directions that are not orthogonal to each other.

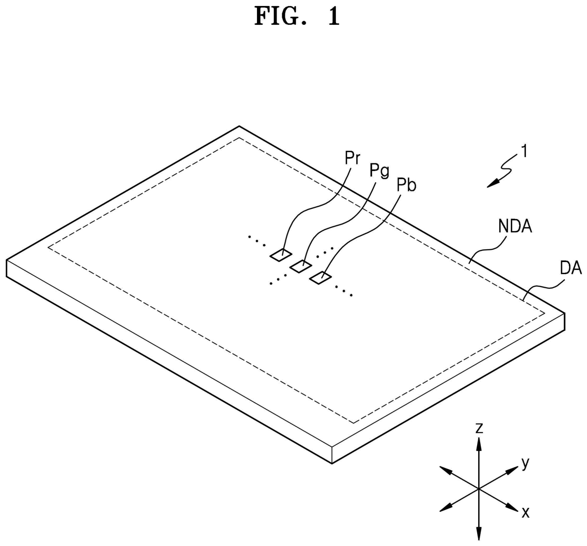

FIG. 1 is a schematic perspective view of a display apparatus 1 according to one or more embodiments of the present disclosure.

Referring to FIG. 1, the display apparatus 1 may include a display area DA and a non-display area NDA outside (e.g., around) the display area DA. The display apparatus 1 may provide an image through an array of a plurality of pixels that are two-dimensionally arranged in an x-y plane in the display area DA. The plurality of pixels may include a first pixel, a second pixel, and a third pixel. Hereinafter, for convenience of description, one or more embodiments in which the first pixel is a green pixel Pg, the second pixel is a red pixel Pr, and the third pixel is a blue pixel Pb will be described. However, embodiments of the disclosure are not limited thereto.

The red pixel Pr, the green pixel Pg, and the blue pixel Pb are regions capable of emitting red color light, green color light, and blue color light, respectively, and the display apparatus 1 may provide an image by using light emitted from the red pixel Pr, the green pixel Pg, and the blue pixel Pb.

The non-display area NDA is an area that does not provide an image and may completely surround the display area DA. A driver or main voltage lines (e.g., a common main voltage line and a driving main voltage line) configured to provide an electrical signal or power to pixel circuits may be arranged in the non-display area NDA. The non-display area NDA may include a pad, which is an area to which an electronic element or a printed circuit board may be electrically connected.

The display area DA may have a polygonal shape including a quadrangle, as illustrated in FIG. 1. For example, in one or more embodiments, the display area DA may have a rectangular shape in which a horizontal length is greater than a vertical length, a rectangular shape in which a horizontal length is less than a vertical length, or a square shape. In one or more embodiments, the display area DA may have one or more suitable shapes, such as an ellipse and/or a circle.

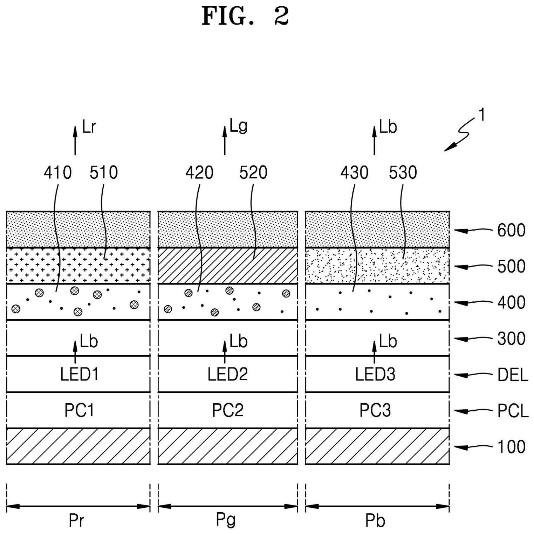

FIG. 2 is a cross-sectional view schematically showing pixels of a display apparatus 1 according to one or more embodiments of the present disclosure.

Referring to FIG. 2, the display apparatus 1 may include a circuit layer PCL on a first substrate 100. The circuit layer PCL may include first to third pixel circuits PC1, PC2, and PC3, and the first to third pixel circuits PC1, PC2, and PC3 may be electrically connected to first to third light-emitting diodes LED1, LED2, and LED3 of a display element layer DEL, respectively.

In one or more embodiments, each of the first to third light-emitting diodes LED1, LED2, and LED3 may include an organic light-emitting diode including an organic material. In one or more embodiments, each of the first to third light-emitting diodes LED1, LED2, and LED3 may be an inorganic light-emitting diode including an inorganic material. The inorganic light-emitting diode may include a PN junction diode including inorganic semiconductor-based materials. When a voltage is applied to the PN junction diode in a forward direction, holes and electrons may be injected, and energy generated by the recombination of the holes and electrons may be converted into light energy to emit light of a certain color. The inorganic light-emitting diode described herein may have a width of several to several hundred micrometers or several to several hundred nanometers. In one or more embodiments, each of the first to third light-emitting diodes LED1, LED2, and LED3 may be a light-emitting diode including quantum dots. As described above, an emission layer of each of the first to third light-emitting diodes LED1, LED2, and LED3 may include an organic material, include an inorganic material, include quantum dots, include an organic material and quantum dots, or include an inorganic material and quantum dots.

In one or more embodiments, the first to third light-emitting diodes LED1, LED2, and LED3 may be to emit light of a same color. For example, in one or more embodiments, light (e.g., blue color light Lb) emitted from the first to third light-emitting diodes LED1, LED2, and LED3 may pass through an encapsulation layer 300 on the display element layer DEL and then pass through a functional layer 400.

The functional layer 400 may include optical portions that transmit light (e.g., the blue color light Lb) emitted from the display element layer DEL with or without converting the color of the light. For example, in one or more embodiments, the functional layer 400 may include color conversion portions that convert the light (e.g., the blue color light Lb) emitted from the display element layer DEL into light of another color, and a transmissive portion that transmits the light (e.g., the blue color light Lb) emitted from the display element layer DEL without converting the color of the light. In one or more embodiments, the functional layer 400 may include a first color conversion portion 410 corresponding to a red pixel Pr, a second color conversion portion 420 corresponding to a green pixel Pg, and a transmissive portion 430 corresponding to a blue pixel Pb. The first color conversion portion 410 may convert blue color light Lb into red color light Lr, and the second color conversion portion 420 may convert the blue color light Lb into green color light Lg. The transmission unit portion 430 may allow the blue color light Lb to pass through without converting the blue color light Lb.

The color filter layer 500 may be arranged on the functional layer 400. The color filter layer 500 may include first to third color filters 510, 520, and 530 having different colors. For example, in one or more embodiments, the first color filter 510 may be a red color filter, the second color filter 520 may be a green color filter, and the third color filter 530 may be a blue color filter.

Light color-converted through the functional layer 400 and light transmitted therethrough may pass through the first to third color filters 510, 520, and 530, and thus, color purity may be improved. In addition, the color filter layer 500 may prevent or reduce external light (e.g., light incident from the outside of the display apparatus 1 toward the display apparatus 1) from being reflected and recognized by a user.

A second substrate 600 may be arranged on the color filter layer 500. The second substrate 600 may include glass or a light-transmitting organic material. For example, in one or more embodiments, the second substrate 600 may include a light-transmitting organic material, such as an acrylic resin.

In one or more embodiments, the second substrate 600 may be a type (kind) of substrate, and after the color filter layer 500 and the functional layer 400 are formed on the second substrate 600, the functional layer 400 may be integrated with the encapsulation layer 300 to face the encapsulation layer 300.

In one or more embodiments, after the functional layer 400 and the color filter layer 500 are sequentially formed on the encapsulation layer 300, the second substrate 600 may be directly applied and cured on the color filter layer 500. In one or more embodiments, another optical film, such as an anti-reflection (AR) film, may be arranged on the second substrate 600.

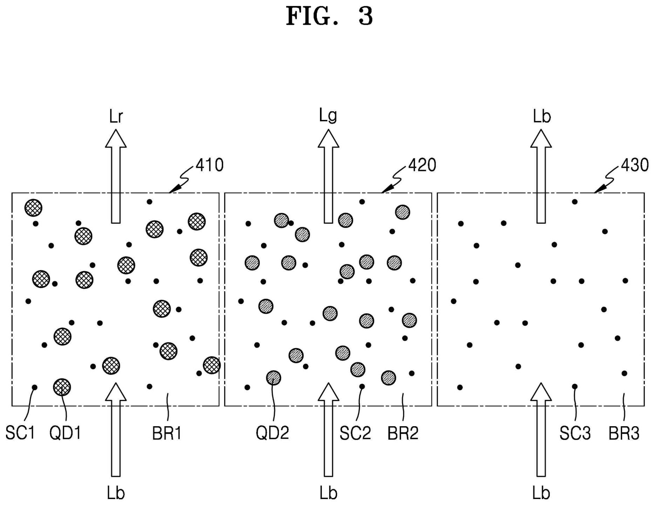

FIG. 3 shows optical portions of the functional layer 400 of the display apparatus 1 according to one or more embodiments of the present disclosure.

Referring to FIG. 3, the first color conversion portion 410 may convert incident blue color light Lb into red color light Lr. As shown in FIG. 3, the first color conversion portion 410 may include a first base resin (or photosensitive polymer) BR1, and first quantum dots QD1 and first scattering particles SC1 dispersed in the first base resin BR1.

The first quantum dots QD1 may be excited by the blue color light Lb and isotropically emit the red color light Lr having a wavelength longer than the wavelength of the blue color light Lb. The first base resin BR1 may be an organic material having light transmittance. The first scattering particles SC1 may scatter blue color light Lb that is not absorbed by the first quantum dots QD1 so that more first quantum dots QD1 are excited, thereby increasing color conversion efficiency. The first scattering particles SC1 may be, for example, titanium oxide (TiO₂) particles or metal particles. The first quantum dots QD1 may be selected from among a Group II-VI compound, a Group III-V compound, a Group IV-VI compound, a Group IV element, a Group IV compound, and a combination thereof.

The second color conversion portion 420 may convert incident blue color light Lb into green color light Lg. The second color conversion portion 420 may include a second base resin BR2, and second quantum dots QD2 and second scattering particles SC2 dispersed in the second base resin BR2, as illustrated in FIG. 3.

The second quantum dots QD2 may be excited by the blue color light Lb to isotropically emit the green color light Lg having a longer wavelength than the blue color light Lb. The second base resin BR2 may be an organic material having light transmittance. The second scattering particles SC2 may scatter blue color light Lb that is not absorbed by the second quantum dots QD2 so that more second quantum dots QD2 are excited, thereby increasing color conversion efficiency. The second scattering particles SC2 may be, for example, TiO₂ particles or metal particles. The second quantum dots QD2 may be selected from among a Group II-VI compound, a Group III-V compound, a Group IV-VI compound, a Group IV element, a Group IV compound, and a combination thereof.

In one or more embodiments, the first quantum dots QD1 and the second quantum dots QD2 may include a same material (e.g., a same compound). In this regard, the sizes of the first quantum dots QD1 may be greater than the sizes of the second quantum dots QD2.

The transmissive portion 430 may be to transmit the blue color light Lb without converting the blue color light Lb incident to the transmissive portion 430. The transmissive portion 430 may include a third base resin BR3 in which third scattering particles SC3 are dispersed, as illustrated in FIG. 3. The third base resin BR3 may be an organic material having light transmittance, such as a silicone resin or an epoxy resin, and/or may be a same material as the first and second base resins BR1 and BR2. The third scattering particles SC3 may scatter and emit blue color light Lb, and may include a same material as the first and second scattering particles SC1 and SC2.

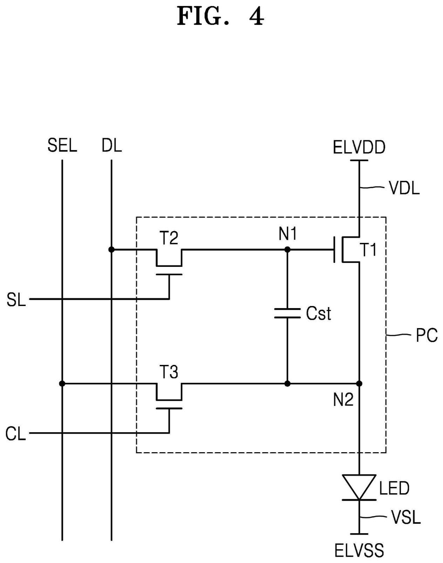

FIG. 4 is an equivalent circuit diagram showing a light-emitting diode LED and a pixel circuit PC electrically connected to the light-emitting diode LED, which are included in the display apparatus 1 (see FIG. 1), according to one or more embodiments of the present disclosure.

Referring to FIG. 4, a pixel electrode (e.g., an anode) of the light-emitting diode LED may be connected to the pixel circuit PC, and an opposite electrode (e.g., a cathode) of the light-emitting diode LED may be connected to a common voltage line VSL configured to provide a common power voltage ELVSS. The light-emitting diode LED may be to emit light with a brightness corresponding to the amount of current supplied from the pixel circuit PC.

The light-emitting diode LED of FIG. 4 may correspond to any one of the first to third light-emitting diodes LED1, LED2, and LED3 illustrated in FIG. 2, and the pixel circuit PC of FIG. 4 may correspond to any one of the first to third pixel circuits PC1, PC2, and PC3 illustrated in FIG. 2.

The pixel circuit PC may control the amount of current flowing from a driving voltage line VDL configured to provide a driving power voltage ELVDD in response to a data signal to the common voltage line VSL configured to provide the common power voltage ELVSS, via the light-emitting diode LED. The pixel circuit PC may include a first transistor T1, a second transistor T2, a third transistor T3, and a storage capacitor Cst.

Each of the first transistor T1, the second transistor T2, and the third transistor T3 may be an oxide semiconductor thin film transistor including a semiconductor layer composed of an oxide semiconductor, or a silicon semiconductor thin film transistor including a semiconductor layer composed of polysilicon. Depending on the type (kind) of the transistor, a first electrode may be one among a source electrode and a drain electrode of the transistor, and a second electrode may be the other among the source electrode and the drain electrode.

The first transistor T1 may be a driving transistor, and a first electrode of the first transistor T1 may be connected to the driving voltage line VDL configured to supply the driving power voltage ELVDD, and a second electrode of the first transistor T1 may be connected to the pixel electrode of a light-emitting diode LED. One of the first electrode and the second electrode of the first transistor T1 may correspond to a drain, and the other may correspond to a source. A gate electrode of the first transistor T1 may be connected to a first node N1. The first transistor T1 may be configured to control, in response to a voltage of the first node N1, the amount of current flowing through the light-emitting diode LED from the driving power voltage ELVDD.

The second transistor T2 may be a data writing transistor, and a first electrode of the second transistor T2 may be connected to a data line DL and a second electrode of the second transistor T2 may be connected to the first node N1. One of the first electrode and the second electrode of the second transistor T2 may correspond to a drain and the other may correspond to a source. A gate electrode of the second transistor T2 may be connected to a first gate line (hereinafter, referred to as a scan line SL). The second transistor T2 may be configured to be turned on if (e.g., when) a scan signal is supplied to the scan line SL and electrically connect the data line DL and the first node N1.

The third transistor T3 may be an initialization transistor, and the third transistor T3 may be configured to initialize the pixel electrode of the light-emitting diode LED in an operation period (e.g., an image display period) of the display apparatus 1 (see FIG. 1) and to read out a sensing signal of the pixel circuit PC in an operation period (e.g., a sensing period) of the display apparatus 1 (see FIG. 1). The sensing signal may be used to determine and compensate for pixel deterioration. One of a first electrode and a second electrode of the third transistor T3 may correspond to a drain and the other may correspond to a source. The first electrode of the third transistor T3 may be connected to a second node N2, and the second electrode of the third transistor T3 may be connected to a sensing-initialization line SEL. A gate electrode of the third transistor T3 may be connected to a second gate line (hereinafter, referred to as a sensing control line CL).

The storage capacitor Cst may be connected between the first node N1 and the second node N2. For example, a first capacitor electrode of the storage capacitor Cst may be connected to the gate electrode of the first transistor T1, and a second capacitor electrode of the storage capacitor Cst may be connected to the pixel electrode of the light-emitting diode LED.

Although FIG. 4 illustrates an example in which the first transistor T1, the second transistor T2, and the third transistor T3 are all NMOS transistors, embodiments of the present disclosure are not limited thereto. For example, in one or more embodiments, one or more selected from among the first transistor T1, the second transistor T2, and the third transistor T3 may be PMOS transistors.

Although three transistors are illustrated in FIG. 4, embodiments of the present disclosure are not limited thereto. For example, in one or more embodiments, the pixel circuit PC may include four or more transistors.

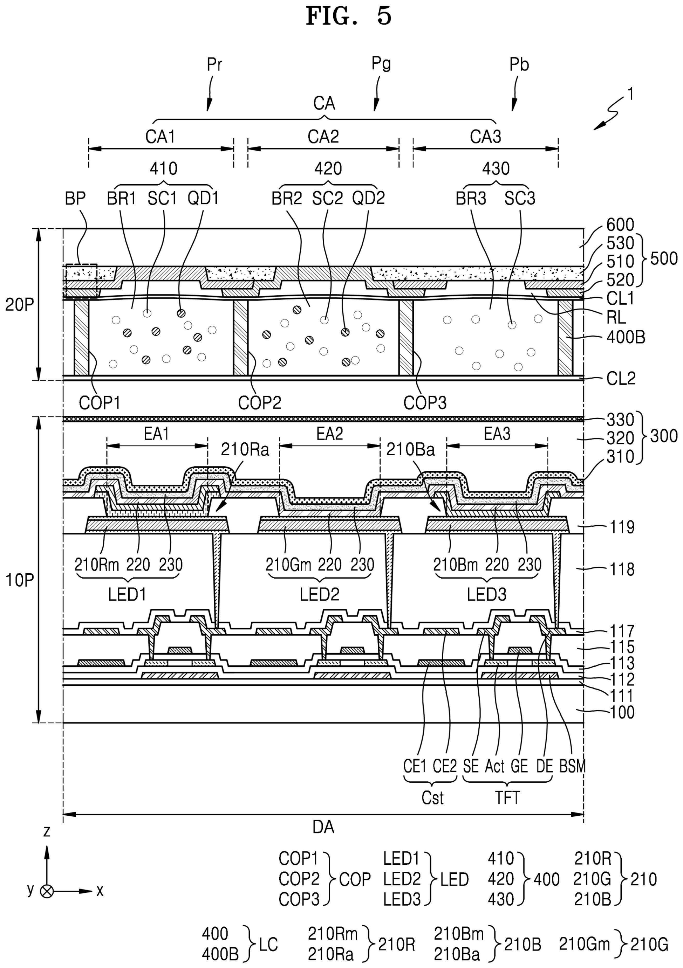

FIG. 5 is a schematic cross-sectional view of a portion of a display apparatus 1 according to one or more embodiments of the present disclosure.

Referring to FIG. 5, the display apparatus 1 may include a red pixel Pr, a green pixel Pg, and a blue pixel Pb arranged on a display area DA. This is merely an example, and the display apparatus 1 may include more pixels. Although FIG. 5 illustrates that the red pixel Pr, the green pixel Pg, and the blue pixel Pb are adjacent to each other, in one or more embodiments, the red pixel Pr, the green pixel Pg, and the blue pixel Pb may not be adjacent pixels.

The red pixel Pr, the green pixel Pg, and the blue pixel Pb may implement different light. For example, in one or more embodiments, the red pixel Pr may implement red color light, the green pixel Pg may implement green color light, and the blue pixel Pb may implement blue color light.

In one or more embodiments, the display apparatus 1 may include a lower panel 10P and an upper panel 20P. The lower panel 10P may include a first substrate 100 and a light-emitting element arranged on the first substrate 100. The light-emitting element may include an intermediate layer 220 including an emission layer. In one or more embodiments, the lower panel 10P may include a first light-emitting diode LED1, a second light-emitting diode LED2, and a third light-emitting diode LED3 each arranged on the first substrate 100. The first light-emitting diode LED1, the second light-emitting diode LED2, and the third light-emitting diode LED3 may commonly include the intermediate layer 220 including the emission layer.

The stacked structure of the lower panel 10P will be described in more detail later.

The first substrate 100 may include a glass material, a ceramic material, a metal material, or a material that is flexible or bendable. When the first substrate 100 is flexible or bendable, the first substrate 100 may include a polymer resin, such as polyethersulfone, polyacrylate, polyetherimide, polyethylene naphthalate, polyethylene terephthalate, polyphenylene sulfide, polyarylate, polyimide, polycarbonate, or cellulose acetate propionate. The first substrate 100 may have a single-layer or multi-layer structure including one or more of the aforementioned materials, and in embodiments of a multi-layer structure, the first substrate 100 may further include an inorganic layer. In one or more embodiments, the first substrate 100 may have a structure including organic/inorganic/organic material layers.

In one or more embodiments, a barrier layer may be further included between the first substrate 100 and a first buffer layer 111. The barrier layer may prevent or reduce impurities from the first substrate 100 and/or the like from penetrating into a semiconductor layer Act. The barrier layer may include an inorganic material such as an oxide or a nitride, an organic material, or an organic-inorganic composite, and may have a single-layer structure or a multi-layer structure including an inorganic material and an organic material.

A bias electrode BSM may be arranged on the first buffer layer 111 to correspond to a thin-film transistor TFT. In one or more embodiments, a voltage may be applied to the bias electrode BSM. In addition, the bias electrode BSM may prevent or reduce external light from reaching the semiconductor layer Act. Accordingly, the characteristics of the thin-film transistor TFT may be stabilized. In one or more embodiments, the bias electrode BSM may not be provided.

The semiconductor layer Act may be arranged on a second buffer layer 112 arranged on the bias electrode BSM and the first buffer layer 111. In one or more embodiments, the semiconductor layer Act may include amorphous silicon or polysilicon. In one or more embodiments, the semiconductor layer Act may include an oxide of at least one material selected from the group consisting of indium (In), gallium (Ga), tin (Sn), zirconium (Zr), vanadium (V), hafnium (Hf), cadmium (Cd), germanium (Ge), chromium (Cr), titanium (Ti), aluminium (Al), cesium (Cs), cerium (Ce), and zinc (Zn). In one or more embodiments, the semiconductor layer Act may include a Zn oxide-based material, such as Zn oxide, In-Zn oxide, and/or Ga-In-Zn oxide. In one or more embodiments, the semiconductor layer Act may include an In-Ga-Zn-O (IGZO), In-Sn-Zn-O (ITZO), or In-Ga-Sn-Zn-O (IGTZO) semiconductor containing a metal, such as indium (In), gallium (Ga), or tin (Sn), in ZnO. The semiconductor layer Act may include a channel region, and a source region and a drain region respectively arranged on two opposite sides of the channel region. The semiconductor layer Act may include a single layer or multiple layers.

A gate electrode GE may be arranged on the semiconductor layer Act with a gate insulating layer 113 therebetween. The gate electrode GE may at least partially overlap the semiconductor layer Act. The gate electrode GE may include molybdenum (Mo), aluminium (Al), copper (Cu), titanium (Ti), and/or the like, and may include a single layer or multiple layers. For example, in one or more embodiments, the gate electrode GE may include a single layer of Mo. A first electrode CE1 of a storage capacitor Cst may be arranged on a same layer as the gate electrode GE. The first electrode CE1 may include a same material as the gate electrode GE.

In FIG. 5, the gate electrode GE of the thin-film transistor TFT and the first electrode CE1 of the storage capacitor Cst are separately arranged. However, in one or more embodiments, the storage capacitor Cst may overlap the thin-film transistor TFT. In these embodiments, the gate electrode GE of the thin-film transistor TFT may function as the first electrode CE1 of the storage capacitor Cst.

An interlayer insulating layer 115 may be provided to cover the gate electrode GE and the first electrode CE1 of the storage capacitor Cst. The interlayer insulating layer 115 may include silicon oxide (SiO₂), silicon nitride (SiN_{X}), silicon oxynitride (SiON), aluminium oxide (Al₂O₃), titanium oxide (TiO₂), tantalum oxide (Ta₂O₅), hafnium oxide (HfO₂), zinc oxide (ZnO), and/or the like.

A second electrode CE2 of the storage capacitor Cst, a source electrode SE, a drain electrode DE, and/or the like may be arranged on the interlayer insulating layer 115.

The second electrode CE2 of the storage capacitor Cst, the source electrode SE, and the drain electrode DE may each include a conductive material including molybdenum (Mo), aluminium (Al), copper (Cu), titanium (Ti), and/or the like, and may include a multilayer or a single layer including one or more of the aforementioned materials. For example, in one or more embodiments, the second electrode CE2, the source electrode SE, and the drain electrode DE may each have a multi-layer structure including Ti/Al/Ti layers. The source electrode SE and the drain electrode DE may be respectively connected to the source region and the drain region of the semiconductor layer Act through a corresponding contact hole.

The second electrode CE2 of the storage capacitor Cst may overlap the first electrode CE1 with the interlayer insulating layer 115 therebetween and may form the storage capacitor Cst. In this regard, the interlayer insulating layer 115 may function as a dielectric layer of the storage capacitor Cst.

A wiring protection layer 117 may be arranged on the second electrode CE2 of the storage capacitor Cst, the source electrode SE, and the drain electrode DE. In this regard, the wiring protection layer 117 may include an inorganic insulating material, such as silicon nitride, silicon oxide, and/or silicon oxynitride. The wiring protection layer 117 may prevent a wiring line including a metal (e.g., copper, and/or the like), which may be damaged by an etchant during the process of manufacturing the display apparatus 1, from being exposed to an etching environment. In one or more embodiments, the wiring protection layer 117 may not be provided.

A planarization layer 118 may be arranged on the wiring protection layer 117. The planarization layer 118 may be formed as a single layer or multilayer of a film including an organic material and may provide a flat upper surface. The planarization layer 118 may include a general-purpose polymer, such as a benzocyclobutene (BCB) polymer, polyimide, hexamethyldisiloxane (HMDSO), polymethylmethacrylate (PMMA), or polystyrene (PS), a polymer derivative having a phenol-based group, an acryl-based polymer, an imide-based polymer, an acryl ether-based polymer, an amide-based polymer, a fluorine-based polymer, a p-xylene-based polymer, a vinyl alcohol-based polymer, a blend thereof, and/or the like.

A display element may be arranged on the planarization layer 118. In one or more embodiments, the first light-emitting diode LED1, the second light-emitting diode LED2, and the third light-emitting diode LED3 may be arranged on the planarization layer 118. The first light-emitting diode LED1, the second light-emitting diode LED2, and the third light-emitting diode LED3 may include a first pixel electrode 210R, a second pixel electrode 210G, and a third pixel electrode 210B, respectively. In one or more embodiments, the first light-emitting diode LED1, the second light-emitting diode LED2, and the third light-emitting diode LED3 may commonly include the intermediate layer 220 and an opposite electrode 230.

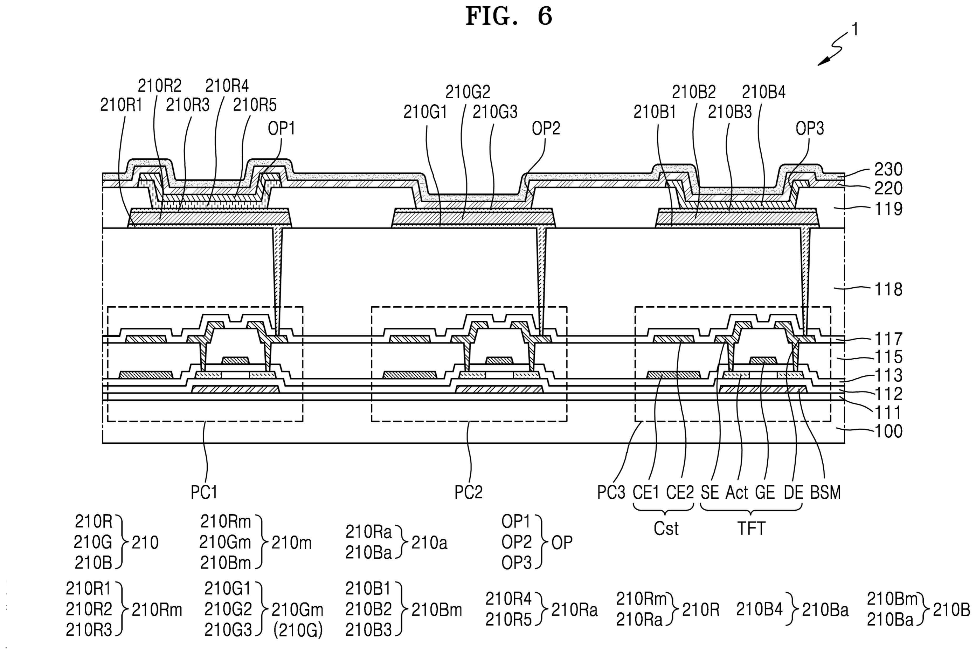

A pixel electrode 210 may include a first pixel electrode 210R, a second pixel electrode 210G, and a third pixel electrode 210B. The pixel electrode 210 may include a (semi)light-transmitting electrode and/or a reflective electrode. In one or more embodiments, the pixel electrode 210 may include a main pixel electrode and an auxiliary pixel electrode. The pixel electrode 210 will be described in more detail with reference to FIG. 6.

A first bank layer 119 may be arranged on the planarization layer 118. The first bank layer 119 may have openings that expose central portions of the first pixel electrode 210R, the second pixel electrode 210G, and the third pixel electrode 210B, respectively. The first bank layer 119 may cover an edge (or end) of each of the first pixel electrode 210R, the second pixel electrode 210G, and the third pixel electrode 210B. The first bank layer 119 may define a first emission area EA1 of the first light-emitting diode LED1, a second emission area EA2 of the second light-emitting diode LED2, and a third emission area EA3 of the third light-emitting diode LED3. The first bank layer 119 may prevent or reduce arcs and/or the like from occurring at the edges of the first pixel electrode 210R, the second pixel electrode 210G, and the third pixel electrode 210B by increasing a distance between the edges of the first pixel electrode 210R, the second pixel electrode 210G, and the third pixel electrode 210B and the opposite electrode 230 above the first pixel electrode 210R, the second pixel electrode 210G, and the third pixel electrode 210B.

The first bank layer 119 may be formed by a method, such as spin coating, and may include one or more organic insulating materials selected from the group consisting of polyimide, polyamide, acrylic resin, benzocyclobutene resin, and phenol resin.

The emission layer of the intermediate layer 220 commonly included in the first light-emitting diode LED1, the second light-emitting diode LED2, and the third light-emitting diode LED3 may include an organic material including a fluorescent or phosphorescent material that emits red color light, green color light, blue color light, or white color light. The emission layer may include a low-molecular weight organic material or a high-molecular weight organic material. In one or more embodiments, the intermediate layer 220 may selectively further include one or more functional layers, such as a hole transport layer (HTL), a hole injection layer (HIL), an electron transport layer (ETL), and/or an electron injection layer (EIL), which are independently arranged below or above the emission layer. FIG. 5 illustrates an example in which the intermediate layer 220 is integrally formed as a single body over the first pixel electrode 210R, the second pixel electrode 210G, and the third pixel electrode 210B. However, embodiments of the present disclosure are not limited thereto, and one or more suitable modifications may be made. For example, in one or more embodiments, the intermediate layer 220 may be arranged to correspond to each of the first pixel electrode 210R, the second pixel electrode 210G, and the third pixel electrode 210B. In one or more embodiments, the emission layer included in the intermediate layer 220 may be an emission layer that emits blue color light. For example, the emission layer may be to emit light having a wavelength in a range of about 450 nanometers (nm) to about 495 nm.

In one or more embodiments, the first light-emitting diode LED1, the second light-emitting diode LED2, and the third light-emitting diode LED3 may each have a tandem structure in which a plurality of light-emitting element stacks are stacked. In these embodiments, the intermediate layer 220 may include a plurality of emission layers and a charge generation layer.

The opposite electrode 230 may be located on the intermediate layer 220 to correspond to the first pixel electrode 210R, the second pixel electrode 210G, and the third pixel electrode 210B. The opposite electrode 230 may be integrally formed as a single body in a plurality of organic display elements. In one or more embodiments, the opposite electrode 230 may be a semi-transmissive electrode (or a semi-transparent electrode), and may include a metal thin film having a low work function and including Li, Ca, LiF/Ca, LiF/Al, Al, Ag, Mg, or a compound thereof. In one or more embodiments, a transparent conductive oxide (TCO) film, such as an ITO, IZO, ZnO, or In₂O₃ film, may be further arranged on the metal thin film.

In one or more embodiments, first light may be generated in the first emission area EA1 of the first light-emitting diode LED1 and emitted to the outside. The first emission area EA1 may be defined as a portion of the first pixel electrode 210R exposed by an opening in the first bank layer 119. Second light may be generated in the second emission area EA2 of the second light-emitting diode LED2 and emitted to the outside. The second emission area EA2 may be defined as a portion of the second pixel electrodes 210G exposed by an opening in the first bank layer 119. Third light may be generated in the third emission area EA3 of the third light-emitting diode LED3 and emitted to the outside. The third emission area EA3 may be defined as a portion of the third pixel electrodes 210B exposed by an opening of the first bank layer 119.

The first emission area EA1, the second emission area EA2, and the third emission area EA3 may be apart from one another. An area of the display area DA other than the first emission area EA1, the second emission area EA2, and the third emission area EA3 may be a non-emission area. The first emission area EA1, the second emission area EA2, and the third emission area EA3 may be distinguished and defined by the non-emission area. In a plan view, the first emission area EA1, the second emission area EA2, and the third emission area EA3 may be arranged in one or more suitable arrangements, such as a stripe arrangement and a PenTile^{®} arrangement in which the emission areas are arranged in a rhombic shape. PenTile^{®} is a duly registered trademark of Samsung Display Co., Ltd. In a plan view, a shape of the first emission area EA1, a shape of the second emission area EA2, and a shape of the third emission area EA3 may each be one of a polygon, a circle, and an ellipse.

In one or more embodiments, a spacer for preventing mask imprinting may be further provided on the first bank layer 119. The spacer may be formed integrally with the first bank layer 119. For example, in one or more embodiments, the spacer and the first bank layer 119 may be concurrently (e.g., simultaneously) formed in a same process by using a halftone mask process.

Because the first light-emitting diode LED1, the second light-emitting diode LED2, and the third light-emitting diode LED3 may be easily damaged by moisture and/or oxygen from the outside, they may be protected by being covered with an encapsulation layer 300. The encapsulation layer 300 may cover the display area DA and extend to the outside of the display area DA. The encapsulation layer 300 may include at least one organic encapsulation layer and at least one inorganic encapsulation layer. For example, in one or more embodiments, the encapsulation layer 300 may include a first inorganic encapsulation layer 310, an organic encapsulation layer 320, and a second inorganic encapsulation layer 330.

Because the first inorganic encapsulation layer 310 is formed along the structure thereunder, an upper surface of the first inorganic encapsulation layer 310 may not be flat. The organic encapsulation layer 320 may cover the first inorganic encapsulation layer 310, and unlike the first inorganic encapsulation layer 310, an upper surface of the organic encapsulation layer 320 may be approximately flat.

The first inorganic encapsulation layer 310 and the second inorganic encapsulation layer 330 may each include one or more inorganic materials selected from among aluminium oxide (Al₂O₃), titanium oxide (TiO₂), tantalum oxide (Ta₂O₅), hafnium oxide (HfO₂), zinc oxide (ZnO), silicon oxide (SiO₂), silicon nitride (SiN_{X}), and silicon oxynitride (SiON). The organic encapsulation layer 320 may include a polymer-based material. non-limiting examples of the polymer-based material may include an acrylic resin, an epoxy resin, polyimide, and polyethylene. In one or more embodiments, the organic encapsulation layer 320 may include an acrylate.

Even if (e.g., when) a crack occurs within the encapsulation layer 300 through the multi-layer structure described above, the encapsulation layer 300 may prevent or reduce the crack from being connected between the first inorganic encapsulation layer 310 and the organic encapsulation layer 320 or between the organic encapsulation layer 320 and the second inorganic encapsulation layer 330. Therefore, the formation of a path through which moisture and/or oxygen from the outside may penetrate into the display area DA may be prevented or reduced.

In one or more embodiments, other layers such as a capping layer may be arranged between the first inorganic encapsulation layer 310 and the opposite electrode 230 as needed.

The upper panel 20P may include a second substrate 600, a color filter layer 500, a refractive layer RL, a first capping layer CL1, a light conversion portion LC, and a second capping layer CL2. The second substrate 600 may be arranged on the first substrate 100 so that a light-emitting element is interposed therebetween. The second substrate 600 may be arranged on the first light-emitting diode LED1, the second light-emitting diode LED2, and the third light-emitting diode LED3.

The second substrate 600 may include a central area CA overlapping a display element. In one or more embodiments, the central area CA may include a first central area CA1, a second central area CA2, and a third central area CA3. The first central area CA1 may overlap the first light-emitting diode LED1 and/or the first emission area EA1. The second central area CA2 may overlap the second light-emitting diode LED2 and/or the second emission area EA2. The third central area CA3 may overlap the third light-emitting diode LED3 and/or the third emission area EA3.

The second substrate 600 may include a glass material, a metal, or a polymer resin. If (e.g., when) the second substrate 600 is flexible or bendable, the second substrate 600 may include a polymer resin, such as polyethersulfone, polyacrylate, polyetherimide, polyethylene naphthalate, polyethylene terephthalate, polyphenylene sulfide, polyarylate, polyimide, polycarbonate, and/or cellulose acetate propionate. In one or more embodiments, the second substrate 600 may have a multi-layer structure including two layers each including a polymer resin and a barrier layer including an inorganic material, such as silicon oxide (SiO₂), silicon nitride (SiN_{X}), or silicon oxynitride (SiON), arranged between the two layers.

The color filter layer 500 may be arranged on a lower surface of the second substrate 600 opposite to (e.g., facing) the first substrate 100 from the second substrate 600. The color filter layer 500 may include a first color filter 510, a second color filter 520, and a third color filter 530. The first color filter 510 may be arranged on the first central area CA1. The second color filter 520 may be arranged on the second central area CA2. The third color filter 530 may be arranged on the third central area CA3. The first color filter 510, the second color filter 520, and the third color filter 530 may each include a photosensitive resin material. The first color filter 510, the second color filter 520, and the third color filter 530 may each include a dye that represents a unique color. In one or more embodiments, the first color filter 510 may allow only light having a wavelength of about 630 nm to about 780 nm to pass through, the second color filter 520 may allow only light having a wavelength of about 495 nm to about 570 nm to pass through, and the third color filter 530 may allow only light having a wavelength of about 450 nm to about 495 nm to pass through.

The color filter layer 500 may reduce external light reflection of the display apparatus 1. For example, if (e.g., when) external light reaches the first color filter 510, only light having a preset wavelength as described above may pass through the first color filter 510, and light having a wavelength other than the preset wavelength may be absorbed by the first color filter 510. Therefore, of the external light incident on the display apparatus 1, only the light having the preset wavelength may pass through the first color filter 510, and some of the light may be reflected by the opposite electrode 230 and/or the first pixel electrode 210R under the first color filter 510, and then be emitted to the outside again. The first color filter 510 may reduce the external light reflection by allowing only some of the external light incident on the location where the red pixel Pr is located to be reflected to the outside. This description may equally apply to the second color filter 520 and the third color filter 530.

The first color filter 510, the second color filter 520, and the third color filter 530 may overlap one another in certain areas. For example, the first color filter 510, the second color filter 520, and the third color filter 530 may overlap one another between one of the central areas CA and the other of the central areas CA. For example, the first color filter 510, the second color filter 520, and the third color filter 530 may overlap one another between the first central area CA1 and the second central area CA2. In this regard, the third color filter 530 may be arranged between the first central area CA1 and the second central area CA2. The first color filter 510 may extend from the first central area CA1 and overlap the third color filter 530. The second color filter 520 may extend from the second central area CA2 and overlap the third color filter 530.

The first color filter 510, the second color filter 520, and the third color filter 530 may overlap one another between the second central area CA2 and the third central area CA3. The first color filter 510 may be arranged between the second central area CA2 and the third central area CA3. The second color filter 520 may extend from the second central area CA2 and overlap the first color filter 510. The third color filter 530 may extend from the third central area CA3 and overlap the first color filter 510.

The first color filter 510, the second color filter 520, and the third color filter 530 may overlap one another between the third central area CA3 and the first central area CA1. The second color filter 520 may be arranged between the third central area CA3 and the first central area CA1. The third color filter 530 may extend from the third central area CA3 and overlap the second color filter 520. The first color filter 510 may extend from the first central area CA1 and overlap the second color filter 520.

As described above, the first color filter 510, the second color filter 520, and the third color filter 530 may overlap one another to define a light-blocking portion BP. Therefore, the color filter layer 500 may prevent or reduce color mixing even without a separate light-blocking member.

The refractive layer RL may be arranged in the central area CA. The refractive layer RL may be arranged in each of the first central area CA1, the second central area CA2, and the third central area CA3. The refractive layer RL may include an organic material. In one or more embodiments, a refractive index of the refractive layer RL may be lower than a refractive index of the first capping layer CL1. In one or more embodiments, the refractive index of the refractive layer RL may be lower than a refractive index of the color filter layer 500. Therefore, the refractive layer RL may collect light.

The first capping layer CL1 may be arranged on lower surfaces of the color filter layer 500 and the refractive layer RL. In one or more embodiments, the first capping layer CL1 may be arranged between the color filter layer 500 and the light conversion portion LC. The first capping layer CL1 may protect the refractive layer RL and the color filter layer 500. The first capping layer CL1 may prevent or reduce damage or contamination of the refractive layer RL and/or the color filter layer 500 by impurities, such as moisture and/or air, penetrating from the outside. The first capping layer CL1 may include an inorganic material.

The light conversion portion LC may include an upper bank layer 400B and a functional layer 400. The upper bank layer 400B may be arranged on a lower surface of the first capping layer CL1. The upper bank layer 400B may include an organic material. In one or more embodiments, the upper bank layer 400B may include a light-blocking material to function as a light-blocking layer. The light-blocking material may include, for example, at least one of a black pigment, a black dye, black particles, or metal particles.

A plurality of openings may be defined in the upper bank layer 400B. For example, a central opening COP (e.g., COP1, COP2, and COP3) may be defined in the upper bank layer 400B. The central opening COP may overlap the central area CA. In one or more embodiments, a plurality of central openings COP may overlap the central area CA. For example, a first central opening COP1 may overlap the first central area CA1. A second central opening COP2 may overlap the second central area CA2. A third central opening COP3 may overlap the third central area CA3.

The functional layer 400 may fill the central opening COP. In one or more embodiments, the functional layer 400 may include at least one of a quantum dot or a scattering particle. In one or more embodiments, the functional layer 400 may include a first color conversion portion 410, a second color conversion portion 420, and a transmissive portion 430.

The first color conversion portion 410 may overlap the first central area CA1. The first color conversion portion 410 may fill the first central opening COP1. The first color conversion portion 410 may overlap the first emission area EA1. The red pixel Pr may include the first light-emitting diode LED1 and the first color conversion portion 410.

The first color conversion portion 410 may convert light of a first wavelength band generated in the intermediate layer 220 on the first pixel electrode 210R into light of a second wavelength band. For example, if (e.g., when) light having a wavelength of about 450 nm to about 495 nm is generated in the intermediate layer 220 on the first pixel electrode 210R, the first color conversion portion 410 may convert the light into light having a wavelength of about 630 nm to about 780 nm. Accordingly, in the red pixel Pr, the light having a wavelength of about 630 nm to about 780 nm may be emitted to the outside through the second substrate 600. In one or more embodiments, the first color conversion portion 410 may include a first quantum dot QD1, a first scattering particle SC1, and a first base resin BR1. The first quantum dot QD1 and the first scattering particle SC1 may be dispersed in the first base resin BR1.

The second color conversion portion 420 may overlap the second central area CA2. The second color conversion portion 420 may fill the second central opening COP2. The second color conversion portion 420 may overlap the second emission area EA2. The green pixel Pg may include the second light-emitting diode LED2 and the second color conversion portion 420.

For example, the second color conversion portion 420 may convert blue color light generated in the intermediate layer 220 on the second pixel electrode 210G into green color light. For example, if (e.g., when) light of a wavelength in a range of about 450 nm to about 495 nm is generated in the intermediate layer 220 on the second pixel electrode 210G, the second color conversion portion 420 may convert the light into light having a wavelength in a range of about 495 nm to about 570 nm. Therefore, in the green pixel Pg, the light having a wavelength in a range of about 495 nm to about 570 nm may be emitted to the outside through the second substrate 600. In one or more embodiments, the second color conversion portion 420 may include a second quantum dot QD2, a second scattering particle SC2, and a second base resin BR2. The second quantum dot QD2 and the second scattering particle SC2 may be dispersed in the second base resin BR2.

The transmissive portion 430 may overlap the third central area CA3. The transmissive portion 430 may fill the third central opening COP3. The transmissive portion 430 may overlap the third emission area EA3. The blue pixel Pb may include the third light-emitting diode LED3 and the transmissive portion 430.

The transmissive portion 430 may be to emit light generated in the intermediate layer 220 on the third pixel electrode 210B to the outside without wavelength conversion. For example, if (e.g., when) light having a wavelength of about 450 nm to about 495 nm is generated in the intermediate layer 220 on the third pixel electrode 210B, the transmissive portion 430 may be to emit the light to the outside without wavelength conversion. In one or more embodiments, the transmissive portion 430 may include a third scattering particle SC3 and a third base resin BR3. The third scattering particle SC3 may be dispersed in the third base resin BR3. In one or more embodiments, the transmissive portion 430 may not include (e.g., may exclude) quantum dots.

At least one of the first quantum dot QD1 or the second quantum dot QD2 may include a semiconductor material, such as cadmium sulfide (CdS), cadmium telluride (CdTe), zinc sulfide (ZnS), or indium phosphide (InP). The quantum dot may have a size of several nanometers, and the wavelength of light after conversion may vary depending on the size of the quantum dot. In the present disclosure, when a dot, dots, or dot particles are spherical, "diameter" or "size" indicates a particle diameter/size or an average particle diameter/size, and when the particles are non-spherical, the "diameter" or "size" indicates a major axis length or an average major axis length. The diameter/size of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter/size is referred to as D50. D50 refers to the average diameter/size of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

In one or more embodiments, the quantum dot may include a core, and the core of the quantum dot may be selected from among a Group II-VI compound, a Group III-V compound, a Group IV-VI compound, a Group IV element, a Group IV compound, and a combination thereof.

The Group II-VI compound may be selected from among: a binary compound selected from the group consisting of CdSe, CdTe, ZnS, ZnSe, ZnTe, ZnO, HgS, HgSe, HgTe, MgSe, MgS, and a mixture thereof; a ternary compound selected from the group consisting of AgInS, CulnS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof.

The group III-V compound may be selected from among: a binary compound selected from the group consisting of GaN, GaP, GaAs, GaSb, AIN, AlP, AlAs, AlSb, InN, InP, InAs, InSb, and a mixture thereof; a ternary compound selected from the group consisting of GaNP, GaNAs, GaNSb, GaPAs, GaPSb, AINP, AlNAs, AlNSb, AlPAs, AlPSb, InGaP, InNP, InNAs, InNSb, InPAs, InPSb, and a mixture thereof; and a quaternary compound selected from the group consisting of GaAlNP, GaAINAs, GaAINSb, GaAlPAs, GaAlPSb, GalnNP, GalnNAs, GalnNSb, GalnPAs, GalnPSb, InAlNP, InAlNAs, InAlNSb, InAIPAs, InAIPSb, and a mixture thereof.

The IV-VI group compound may be selected from among: a binary compound selected from the group consisting of SnS, SnSe, SnTe, PbS, PbSe, PbTe, and a mixture thereof; a ternary compound selected from the group consisting of SnSeS, SnSeTe, SnSTe, PbSeS, PbSeTe, PbSTe, SnPbS, SnPbSe, SnPbTe, and a mixture thereof; and a quaternary compound selected from the group consisting of SnPbSSe, SnPbSeTe, SnPbSTe, and a mixture thereof. The IV group element may be selected from the group consisting of Si, Ge, and a mixture thereof. The IV group compound may be a binary compound selected from the group consisting of SiC, SiGe, and a mixture thereof.

In this regard, the binary compound, ternary compound, or quaternary compound may exist in a particle at a substantially uniform concentration, or may exist in the same particle by being divided into states between which the concentration distribution is partially different. In one or more embodiments, the quantum dot may have a core/shell structure in which one quantum dot surrounds another quantum dot. An interface between the core and the shell may have a concentration gradient in which the concentration of an element in the shell decreases toward the center.

In one or more embodiments, the quantum dot may have a core-shell structure including a core including nanocrystals and a shell around (e.g., surrounding) the core. The shell of the quantum dot may function as a protective layer to prevent or reduce chemical modification of the core and maintain semiconductor properties and/or as a charging layer to impart electrophoretic properties to the quantum dot. The shell may include a single layer or a multilayer. The interface between the core and the shell may have a concentration gradient in which the concentration of an element present in the shell decreases toward the center. Examples of the shell of the quantum dot may include a metal or non-metal oxide, a semiconductor compound, or a combination thereof.

For example, the metal or non-metal oxide may be a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO, or a ternary compound, such as MgAl₂O₄, CoFe₂O₄, NiFe₂O₄, and/or CoMn₂O₄. However, embodiments of the disclosure are not limited thereto.

In addition, the semiconductor compound suitable as a shell may be CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, and/or AlSb. However, embodiments of the disclosure are not limited thereto.

In addition, the shape of the quantum dot is not particularly limited, and may be a shape commonly used in the art, for example, a shape of, such as, a spherical nanoparticle, a pyramidal nanoparticle, a multi-arm nanoparticle, a cubic nanoparticle, a nanotube, a nanowire, a nanofiber, or a nanoplate particle may be used.

The quantum dot may tune the color of emitted light by adjusting the particle size thereof, and accordingly, the quantum dot may have one or more suitable emission colors, such as blue, red, and green.

The first scattering particle SC1, the second scattering particle SC2, and the third scattering particle SC3 may scatter light so that more light may be emitted. The first scattering particle SC1, the second scattering particle SC2, and the third scattering particle SC3 may increase light emission efficiency. At least one of the first scattering particle SC1, the second scattering particle SC2, or the third scattering particle SC3 may be any material selected from among metals and metal oxides for evenly scattering light. For example, in one or more embodiments, at least one of the first scattering particle SC1, the second scattering particle SC2, or the third scattering particle SC3 may be at least one selected from among TiO₂, ZrO₂, Al₂O₃, In₂O₃, ZnO, SnO₂, Sb₂O₃, and ITO. In addition, at least one of the first scattering particle SC1, the second scattering particle SC2, or the third scattering particle SC3 may have a refractive index of about 1.5 or more. Accordingly, the light emission efficiency of the functional layer 400 may be improved. In one or more embodiments, at least one of the first scattering particle SC1, the second scattering particle SC2, or the third scattering particle SC3 may not be provided.

The first base resin BR1, the second base resin BR2, and the third base resin BR3 may each include a light-transmitting material. For example, in one or more embodiments, at least one of the first base resin BR1, the second base resin BR2, or the third base resin BR3 may include a polymer resin, such as an acrylic-based resin, a BCB-based resin, or HMDSO.

The second capping layer CL2 may be arranged on a lower surface of the light conversion portion LC. For example, in one or more embodiments, the second capping layer CL2 may be arranged on the upper bank layer 400B and the functional layer 400. The second capping layer CL2 may protect the upper bank layer 400B and the functional layer 400. The second capping layer CL2 may prevent or reduce damage or contamination of the upper bank layer 400B and/or the functional layer 400 by impurities, such as moisture and/or air, penetrating from the outside. The second capping layer CL2 may include an inorganic material.

The display apparatus 1 as described above may be to emit red color light (or light of a first color) to the outside from the red pixel Pr, emit green color light (or light of a second color) to the outside from the green pixel Pg, and emit blue color light (or light of a third color) to the outside from the blue pixel Pb. For example, the display apparatus 1 may display a full-color image.

FIG. 6 is an enlarged cross-sectional view of a portion of a display apparatus 1 according to one or more embodiments of the present disclosure. In FIG. 6, the same/similar reference numerals denote the same/similar elements shown in FIG. 5, and thus, detailed descriptions of the same/similar elements may be simplified or may not be repeated for conciseness.

Referring to FIG. 6, a first pixel circuit PC1 corresponding to a red pixel Pr (see FIG. 5), a second pixel circuit PC2 corresponding to a green pixel Pg (see FIG. 5), and a third pixel circuit PC3 corresponding to a blue pixel Pb (see FIG. 5) may be arranged on a first substrate 100. The first pixel circuit PC1, the second pixel circuit PC2, and the third pixel circuit PC3 may each include a plurality of transistors TFT and a storage capacitor Cst described with reference to FIG. 3 and FIG. 5.

The first pixel circuit PC1, the second pixel circuit PC2, and the third pixel circuit PC3 may be covered by a planarization layer 118, and a light-emitting diode LED (see FIG. 5) may be arranged on the planarization layer 118. For example, a pixel electrode 210 may be arranged on the planarization layer 118. The pixel electrode 210 may include a first pixel electrode 210R electrically connected to the first pixel circuit PC1, a second pixel electrode 210G electrically connected to the second pixel circuit PC2, and a third pixel electrode 210B electrically connected to the third pixel circuit PC3.

In one or more embodiments, the pixel electrode 210 may include a main pixel electrode 210m arranged between the planarization layer 118 and a first bank layer 119, and an auxiliary pixel electrode 210a arranged on the first bank layer 119 and arranged within an opening of the first bank layer 119. For example, the first bank layer 119 may cover an end of the main pixel electrode 210m, and the auxiliary pixel electrode 210a may be arranged within an opening OP of the first bank layer 119, so that the main pixel electrode 210m and the auxiliary pixel electrode 210a may be in direct contact with each other. For example, the main pixel electrode 210m may be deposited before the formation of the first bank layer 119, and the auxiliary pixel electrode 210a may be deposited after the formation of the first bank layer 119.

The main pixel electrode 210m may include a first main pixel electrode 210Rm corresponding to the red pixel Pr (see FIG. 5), a second main pixel electrode 210Gm corresponding to the green pixel Pg (see FIG. 5), and a third main pixel electrode 210Bm corresponding to the blue pixel Pb (see FIG. 5). The main pixel electrode 210m may include a (semi)transmissive electrode and/or a reflective electrode. In one or more embodiments, the first main pixel electrode 210Rm, the second main pixel electrode 210Gm, and the third main pixel electrode 210Bm may each include a reflective layer including Ag, Mg, Al, Pt, Pd, Au, Ni, Nd, Ir, Cr, or a compound thereof, and a transparent or semi-transparent electrode layer formed on the reflective layer. The transparent or semi-transparent electrode layer may include at least one selected from among TCO materials including indium tin oxide (ITO), indium zinc oxide (IZO), zinc oxide (ZnO), indium oxide (In₂O₃), indium gallium oxide (IGO), aluminium zinc oxide (AZO), zinc indium oxide (ZIO), and zinc indium tin oxide (ZITO). As used herein, "TCO" and "TCO materials" refer to transparent conductive oxides such as ITO, IZO, ZnO, In₂O₃, IGO, AZO, ZIO, etc. And "TCO," "TCO material," "transparent conductive oxide," and/or like are used interchangeably in the disclosure.

In one or more embodiments, the first main pixel electrode 210Rm may include a first-1 sub-layer 210R1, a first-2 sub-layer 210R2 arranged on the first-1 sub-layer 210R1, and a first-3 sub-layer 210R3 arranged on the first-2 sub-layer 210R2. In these embodiments, the first-1 sub-layer 210R1 and the first-3 sub-layer 210R3 may be transparent electrode layers, and the first-2 sub-layer 210R2 may be a reflective electrode layer. For example, the first-1 sub-layer 210R1 and the first-3 sub-layer 210R3 may each include a transparent conductive oxide (TCO), and the first-2 sub-layer 210R2 may include a material including Ag, Mg, Al, Pt, Pd, Au, Ni, Nd, Ir, Cr, or a compound thereof. In one or more embodiments, the first main pixel electrode 210Rm may include ITO/Ag/ITO layers.

In one or more embodiments, the second main pixel electrode 210Gm may include a second-1 sub-layer 210G1, a second-2 sub-layer 210G2 arranged on the second-1 sub-layer 210G1, and a second-3 sub-layer 210G3 arranged on the second-2 sub-layer 210G2. The third main pixel electrode 210Bm may include a third-1 sub-layer 210B1, a third-2 sub-layer 210B2 arranged on the third-1 sub-layer 210B1, and a third-3 sub-layer 210B3 arranged on the third-2 sub-layer 210B2. The structure and material of the first main pixel electrode 210Rm may be applied identically to the second main pixel electrode 210Gm and the third main pixel electrode 210Bm. For example, in one or more embodiments, the second main pixel electrode 210Gm and the third main pixel electrode 210Bm may each include ITO/Ag/ITO layers.

The first bank layer 119 may be arranged on the main pixel electrode 210m. The first bank layer 119 may cover the end of the main pixel electrode 210m and include a plurality of openings OP that expose an upper surface of the main pixel electrode 210m. For example, the first bank layer 119 may include a first opening OP1 exposing an upper surface of the first main pixel electrode 210Rm, a second opening OP2 exposing an upper surface of the second main pixel electrode 210Gm, and a third opening OP3 exposing an upper surface of the third main pixel electrode 210Bm.

The auxiliary pixel electrode 210a may be arranged between the main pixel electrode 210m and the intermediate layer 220, and may be arranged on the first bank layer 119 (or within the opening OP of the first bank layer 119). In one or more embodiments, the auxiliary pixel electrode 210a may be arranged differently in each of the red pixel Pr (see FIG. 5), the green pixel Pg (see FIG. 5), and the blue pixel Pb (see FIG. 5). For example, in one or more embodiments, a thickness of the first pixel electrode 210R in the red pixel Pr (see FIG. 5), a thickness of the second pixel electrode 210G in the green pixel Pg (see FIG. 5), and a thickness of the third pixel electrode 210B in the blue pixel Pb (see FIG. 5) may be different from one another.

For example, in one or more embodiments, the first pixel electrode 210R may include a first auxiliary pixel electrode 210Ra arranged on the first main pixel electrode 210Rm, and the first auxiliary pixel electrode 210Ra may include a first auxiliary layer 210R4 and a second auxiliary layer 210R5 arranged on the first auxiliary layer 210R4. The first auxiliary layer 210R4 and the second auxiliary layer 210R5 may each independently include at least one selected from among TCO materials including indium tin oxide (ITO), indium zinc oxide (IZO), zinc oxide (ZnO), indium oxide (In₂O₃), indium gallium oxide (IGO), aluminium zinc oxide (AZO), zinc indium oxide (ZIO), and zinc indium tin oxide (ZITO). The first auxiliary layer 210R4 and the second auxiliary layer 210R5 may each have a thickness of about 100 Å to about 500 Å.

The third pixel electrode 210B may include a second auxiliary pixel electrode 210Ba arranged on the third main pixel electrode 210Bm, and the second auxiliary pixel electrode 210Ba may include a third auxiliary layer 210B4. In one or more embodiments, the third auxiliary layer 210B4 may be formed through a same process as the second auxiliary layer 210R5 of the first auxiliary pixel electrode 210Ra and may include a same material as the second auxiliary layer 210R5. For example, the third auxiliary layer 210B4 may include at least one selected from among TCO materials including indium tin oxide (ITO), indium zinc oxide (IZO), zinc oxide (ZnO), indium oxide (In₂O₃), indium gallium oxide (IGO), aluminium zinc oxide (AZO), zinc indium oxide (ZIO), and zinc indium tin oxide (ZITO). The third auxiliary layer 210B4 may have a thickness of about 100 Å to about 500 Å, similar to the second auxiliary layer 210R5.

The second pixel electrode 210G may only have the second main pixel electrode 210Gm and may not include (e.g., may exclude) the auxiliary pixel electrode 210a. For example, the second main pixel electrode 210Gm may directly contact the intermediate layer 220 within the opening of the first bank layer 119.

In summary, in one or more embodiments, the first pixel electrode 210R may further include the first auxiliary layer 210R4 and the second auxiliary layer 210R5 in addition to the first main pixel electrode 210Rm, the second pixel electrode 210G may include only the second main pixel electrode 210Gm, and the third pixel electrode 210B may further include the third auxiliary layer 210B4 in addition to the third main pixel electrode 210Bm. Accordingly, the thickness of the third pixel electrode 210B may be greater than the thickness of the second pixel electrode 210G, and the thickness of the first pixel electrode 210R may be greater than the thickness of the third pixel electrode 210B.

As described above, because the pixel electrode 210 includes a transparent electrode layer and a reflective electrode layer and the opposite electrode 230 includes a semi-transmissive electrode, a resonance structure may be formed between the pixel electrode 210 and the opposite electrode 230. For example, if (e.g., when) the distance between the pixel electrode 210 and the opposite electrode 230 is configured to satisfy a constructive interference condition, light in each pixel may be repeatedly reflected from the pixel electrode 210 and the opposite electrode 230, thereby decreasing the half-width and increasing the intensity. The light extraction efficiency of the display apparatus 1 may be improved by this microcavity structure.

In this regard, because light having different wavelengths is emitted according to the red pixel Pr (see FIG. 5), the green pixel Pg (see FIG. 5), and the blue pixel Pb (see FIG. 5), in order to improve or optimize the light extraction efficiency, it is desirable to form a light-emitting diode LED (see FIG. 5) to have different resonance distances for each pixel. (Here, the resonance distance may be defined as a distance between the reflective electrode layer of the pixel electrode (210) and the opposite electrode (230).) To this end, in an existing and/or comparable technology, a resonance distance may be controlled or selected for each pixel by arranging emission layers (or resonance control layers) having different thicknesses in the intermediate layer 220. However, although a fine metal mask (FMM) may be used to form the thickness of an emission layer differently for each pixel, in the case of a display apparatus using a large substrate, it is difficult to use the FMM, so that it is difficult to form emission layers (or resonance control layers) having different thicknesses.

Accordingly, the display apparatus 1 according to one or more embodiments of the present disclosure may improve the light extraction efficiency by controlling the resonance distance by using the thickness of the pixel electrode 210 and forming a differential resonance structure for each pixel. In the existing and/or comparable technology, in controlling the resonance distance by using the thickness of the pixel electrode 210, the pixel electrode 210 may be damaged when the thickness of the pixel electrode 210 is adjusted through an etching process after the pixel electrode 210 is deposited.

In contrast, the display apparatus 1 according to one or more embodiments may efficiently improve the light extraction efficiency without damaging the pixel electrode 210 by controlling the resonance distance by adding the auxiliary pixel electrode 210a arranged on the first bank layer 119 instead of the main pixel electrode 210m. For example, an optical length for improving or optimizing the resonance structure of red color light may be greater than an optical length of blue color light, and the optical length of blue color light may be greater than an optical length of green color light. Therefore, in the case of the red pixel Pr (see FIG. 5) that emits red color light having a largest optical length, the resonance distance may be controlled or selected by adding the first auxiliary layer 210R4 and the second auxiliary layer 210R5. In the case of the blue pixel Pb (see FIG. 5) that emits blue color light having a second largest optical length after red color light, the resonance distance may be controlled or selected by adding only the third auxiliary layer 210R4. In the case of the green pixel Pg (see FIG. 5) that emits green color light having a shortest optical length, the resonance distance may be improved or optimized by not arranging the auxiliary pixel electrode 210a. In this way, in the display apparatus 1 according to one or more embodiments, a differential resonance structure may be implemented for each pixel by adjusting the thickness of the pixel electrode 210 by using the auxiliary pixel electrode 210a.

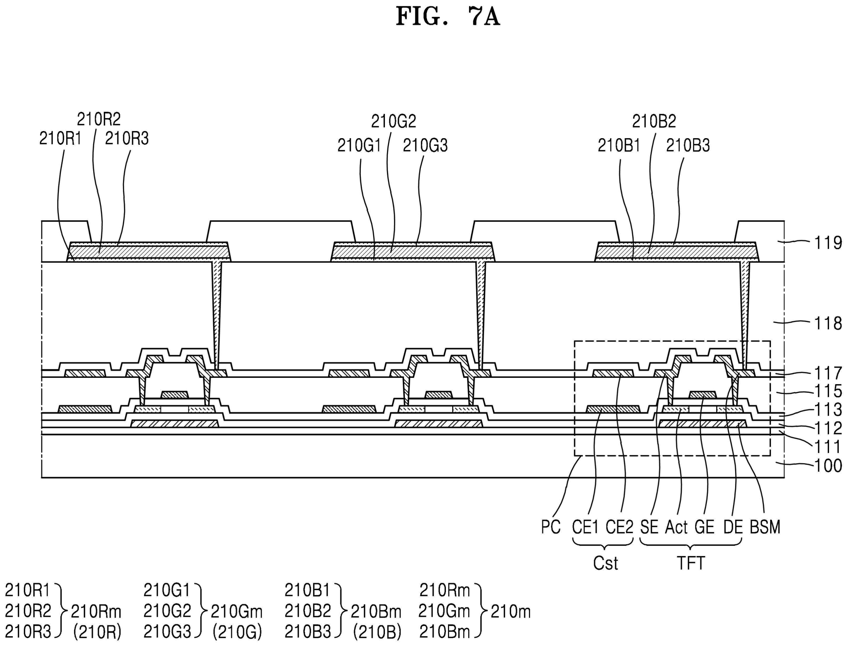

FIGS. 7A to 7J are cross-sectional views schematically showing a process of manufacturing the display apparatus 1 according to one or more embodiments of the present disclosure. In FIGS. 7A to 7J, the same/similar reference numerals denote the same/similar elements shown in FIG. 5 and FIG. 6, and thus, detailed descriptions of the same/similar elements may be simplified or may not be repeated for conciseness.

First, referring to FIG. 7A, the pixel circuit PC may be formed on the first substrate 100, and the planarization layer 118 may be formed to cover the pixel circuit PC. On the planarization layer 118, the first main pixel electrode 210Rm of the first pixel electrode 210R, the second main pixel electrode 210Gm of the second pixel electrode 210G, and the third main pixel electrode 210Bm of the third pixel electrode 210B may be each formed.

For example, a first preliminary sub-layer including a transparent conductive oxide (TCO) such as ITO, a second preliminary sub-layer including a material including Ag, Mg, Al, Pt, Pd, Au, Ni, Nd, Ir, Cr, or a compound thereof, and a third preliminary sub-layer including a transparent conductive oxide TCO such as ITO may be deposited on the planarization layer 118.

After the first preliminary sub-layer, the second preliminary sub-layer, and the third preliminary sub-layer are deposited, the main pixel electrode 210m may be patterned through a photo process and an etching process. For example, the first preliminary sub-layer may be patterned as the first-1 sub-layer 210R1 of the first main pixel electrode 210Rm, the second-1 sub-layer 210G1 of the second main pixel electrode 210Gm, and the third-1 sub-layer 210B1 of the third main pixel electrode 210Bm. The second preliminary sub-layer may be patterned as the first-2 sub-layer 210R2 of the first main pixel electrode 210Rm, the second-2 sub-layer 210G2 of the second main pixel electrode 210Gm, and the third-2 sub-layer 210B2 of the third main pixel electrode 210Bm. The third preliminary sub-layer may be patterned as the first-3 sub-layer 210R3 of the first main pixel electrode 210Rm, the second-3 sub-layer 210G3 of the second main pixel electrode 210Gm, and the third-3 sub-layer 210B2 of the third main pixel electrode 210Bm.

The first bank layer 119 may be formed on the main pixel electrode 210m formed as described above. The first bank layer 119 may include one or more organic insulating materials selected from the group consisting of polyimide, polyamide, acrylic resin, benzocyclobutene resin, and phenol resin, and may be formed by a method such as spin coating. Thereafter, a plurality of openings exposing an upper surface of the main pixel electrode 210m may be formed in the first bank layer 119 through an exposure and development process.

The first bank layer 119 may undergo a cure process to harden the organic material for forming the first bank layer 119. For example, in one or more embodiments, the first bank layer 119 may be thermally cured by performing a cure process at a high temperature (about 150 °C to about 400 °C) for several tens of minutes to several hours.

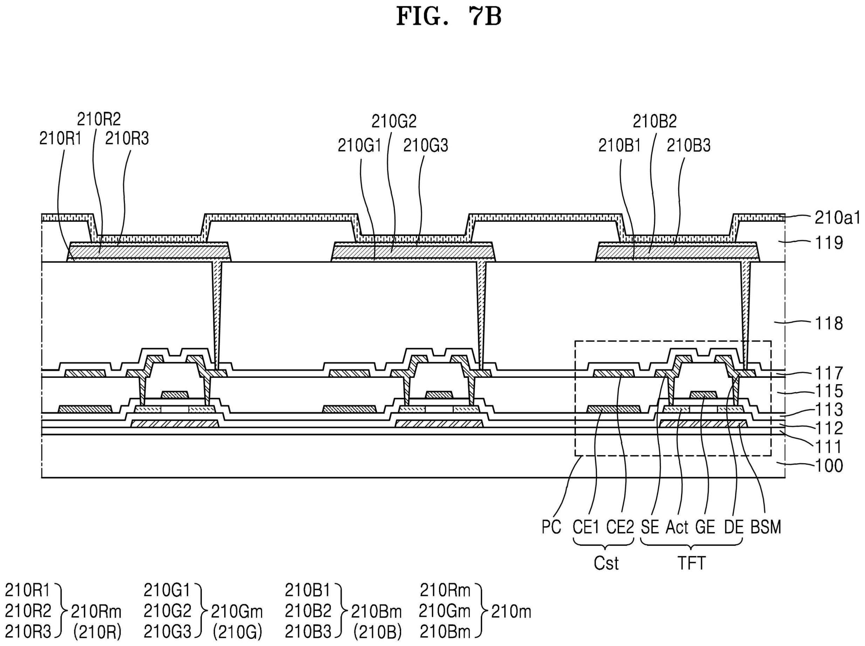

Next, referring to FIG. 7B, a first preliminary auxiliary layer 210a1 may be deposited on the main pixel electrode 210m and the first bank layer 119. The first preliminary auxiliary layer 210a1 may include a TCO material including indium tin oxide (ITO), indium zinc oxide (IZO), zinc oxide (ZnO), indium oxide (In₂O₃), indium gallium oxide (IGO), aluminium zinc oxide (AZO), zinc indium oxide (ZIO), or zinc indium tin oxide (ZITO). In one or more embodiments, the first preliminary auxiliary layer 210a1 may have a thickness of about 100 Å to about 500 Å. The first preliminary auxiliary layer 210a1 may be deposited on the entire surface of the substrate 100.

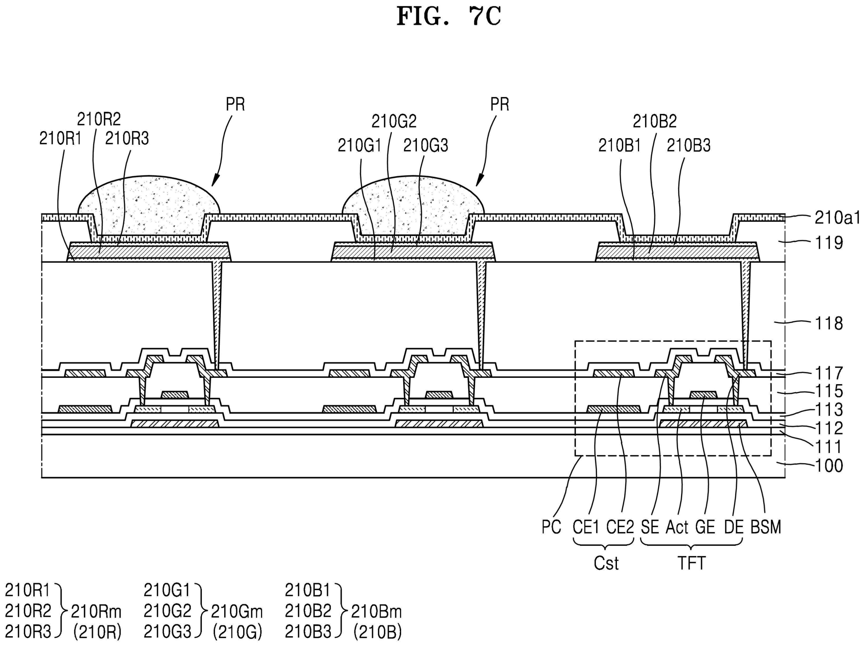

Next, referring to FIG. 7C, a photoresist PR may be formed on the first preliminary auxiliary layer 210a1. In one or more embodiments, the photoresist PR may be formed to overlap the first main pixel electrode 210Rm and the second main pixel electrode 210Gm in a plan view. In one or more other embodiments, the photoresist PR may be formed to overlap only the first main pixel electrode 210Rm in a plan view. The photoresist PR may be patterned by depositing a photoresist material and exposing and developing the photoresist material.

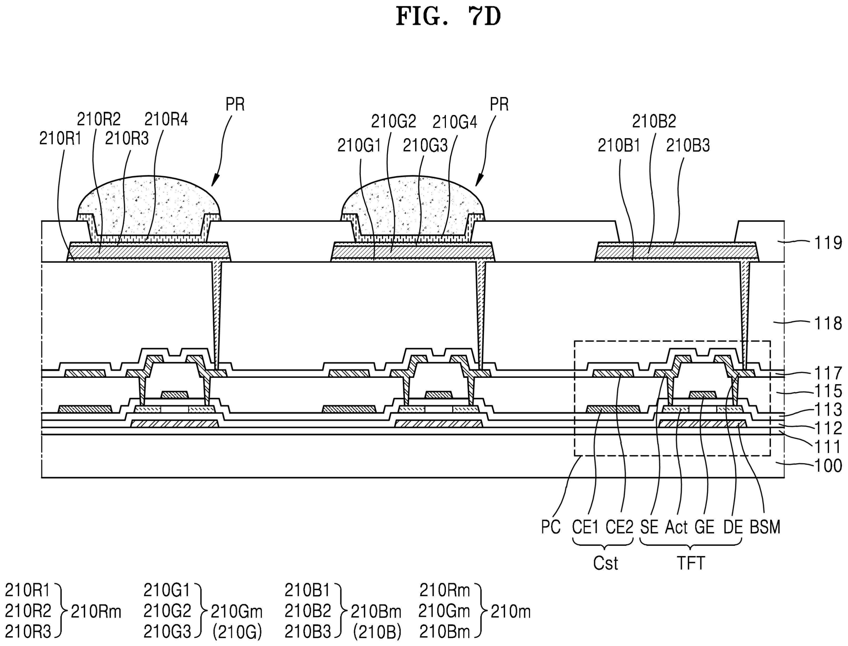

Next, referring to FIG. 7D, a portion of the first preliminary auxiliary layer 210a1 that does not overlap the photoresist PR may be removed. The portion of the first preliminary auxiliary layer 210a may be removed through a wet etch process.

In this regard, even if (e.g., when) the wet etch process is performed, only the portion of the first preliminary auxiliary layer 210a may be removed and the main pixel electrode 210m may not be etched. For example, the main pixel electrode 210m and the first preliminary auxiliary layer 210a1 may include a same TCO material. However, as described above, as the first bank layer 119 undergoes the cure process, the TCO material of the main pixel electrode 210m that has undergone the cure process may be crystallized, and thus, an etching selectivity of the TCO material of the main pixel electrode 210m may be different from that of the TCO material of the first preliminary auxiliary layer 210a1. By using the difference in etching selectivity between the main pixel electrode 210m and the first preliminary auxiliary layer 210a1, the etching process may be set to etch only the first preliminary auxiliary layer 210a1.

Accordingly, the first auxiliary layer 210R4 may be patterned on the first main pixel electrode 210Rm, and a fourth auxiliary layer 210G4 may be patterned on the second main pixel electrode 210Gm. However, as described above with reference to FIG. 7C, in one or more other embodiments, the photoresist PR may not overlap the second main pixel electrode 210Gm. In such embodiments, the fourth auxiliary layer 210G4 may not be formed on the second main pixel electrode 210Gm, and the first auxiliary layer 210R4 may be formed only on the first main pixel electrode 210Rm.

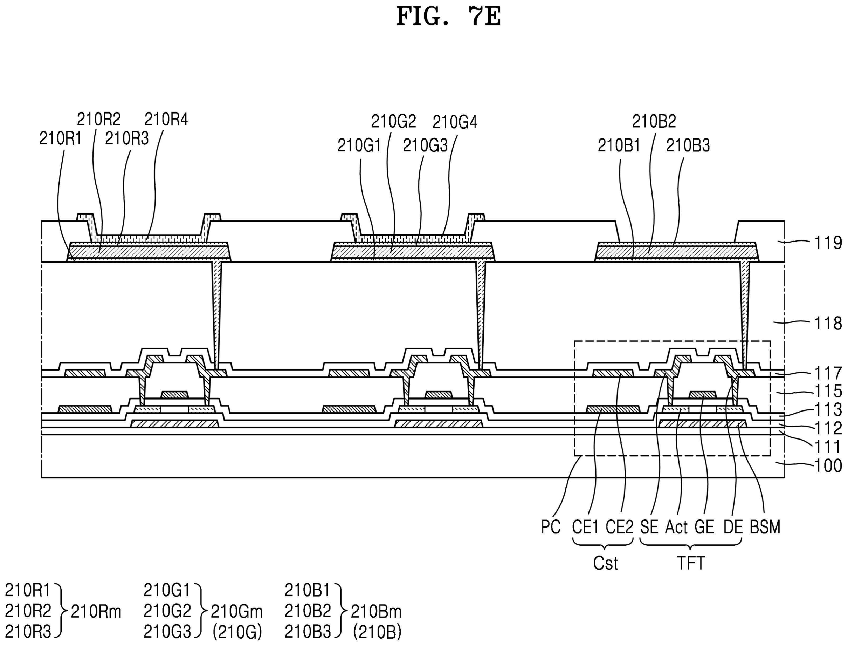

Next, referring to FIG. 7E, the remaining photoresist PR may be removed through a strip process. As the photoresist PR is removed, the first auxiliary layer 210R4 may be arranged on the first main pixel electrode 210Rm, the fourth auxiliary layer 210G4 may be arranged on the second main pixel electrode 210Gm, and no auxiliary layer may be arranged on the third main pixel electrode 210Bm.

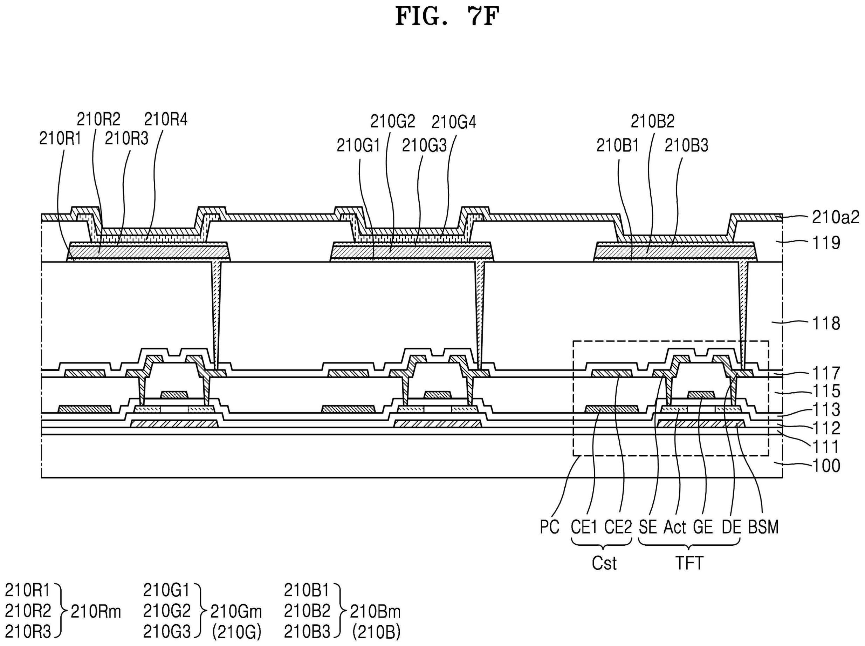

Next, referring to FIG. 7F, a second preliminary auxiliary layer 210a2 may be deposited on the first bank layer 119, the first auxiliary layer 210R4, the fourth auxiliary layer 210G4, and the third main pixel electrode 210Bm. The second preliminary auxiliary layer 210a2 may include a TCO material including indium tin oxide (ITO), indium zinc oxide (IZO), zinc oxide (ZnO), indium oxide (In₂O₃), indium gallium oxide (IGO), aluminium zinc oxide (AZO), zinc indium oxide (ZIO), or zinc indium tin oxide (ZITO). In one or more embodiments, the second preliminary auxiliary layer 210a2 may have a thickness of about 100 Å to about 500 Å. The second preliminary auxiliary layer 210a2 may be deposited on the entire surface of the substrate 100.

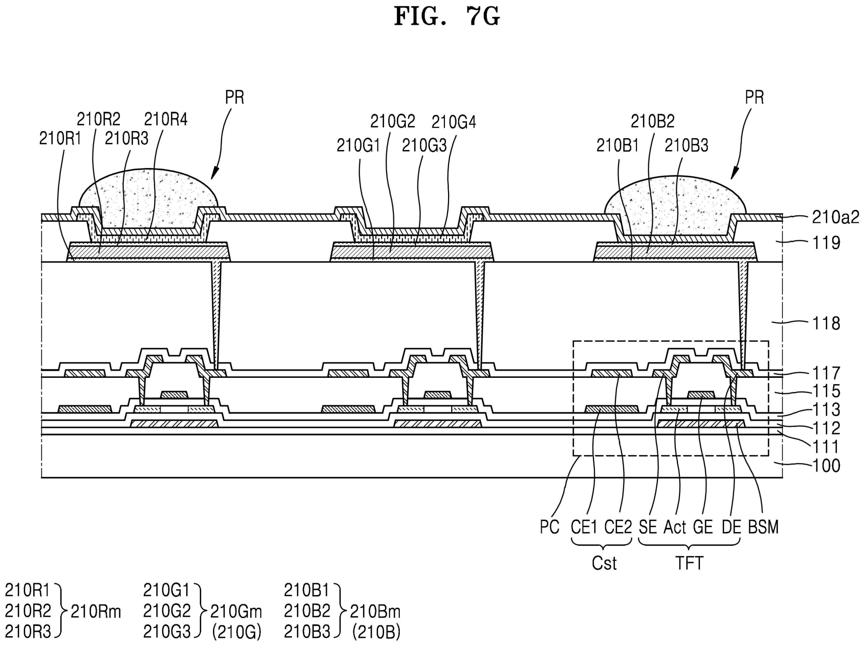

Next, referring to FIG. 7G, a photoresist PR may be formed on the second preliminary auxiliary layer 210a2. In one or more embodiments, the photoresist PR may be formed to overlap the first main pixel electrode 210Rm and the third main pixel electrode 210Bm in a plan view. The photoresist PR may be patterned by depositing a photoresist material and exposing and developing the photoresist material.

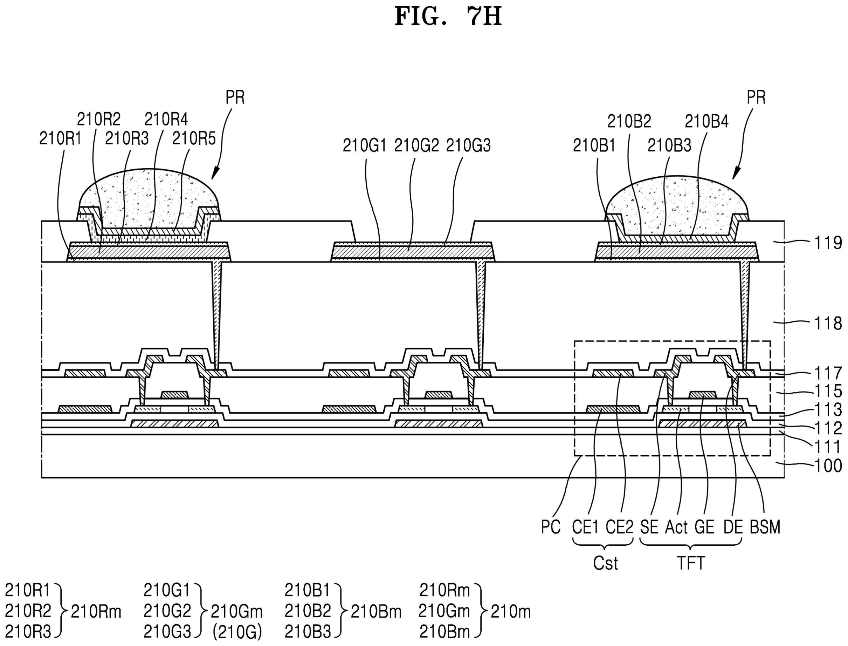

Next, referring to FIG. 7H, a portion of the second preliminary auxiliary layer 210a2 that does not overlap the photoresist PR may be removed. The portion of the second auxiliary layer 210a2 may be removed through a wet etch process.

In this regard, even if (e.g., when) the wet etch process is performed, only the portion of the second preliminary auxiliary layer 210a2 may be removed and the main pixel electrode 210m may not be etched. For example, the main pixel electrode 210m and the second preliminary auxiliary layer 210a2 may include a same TCO material. However, as described above, as the first bank layer 119 undergoes the cure process, the TCO material of the main pixel electrode 210m that has undergone the cure process may be crystallized, and thus, the etching selectivity of the TCO material of the main pixel electrode 210m may be different from that of the TCO material of the preliminary second auxiliary layer 210a2. By using the difference in etching selectivity between the main pixel electrode 210m and the second preliminary auxiliary layer 210a2, the etching process may be set to etch only the second preliminary auxiliary layer 210a2.

Accordingly, the second auxiliary layer 210R5 may be patterned on the first main pixel electrode 210Rm and the first auxiliary layer 210R4, and the third auxiliary layer 210B4 may be patterned on the third main pixel electrode 210Bm. In this regard, the fourth auxiliary layer 210G4 on the second main pixel electrode 210Gm may be removed together with the second preliminary auxiliary layer 210a2 through the etching process. The fourth auxiliary layer 210G4 may be a layer patterned from the first preliminary auxiliary layer 210a1 because the first preliminary auxiliary layer 210a1 and the second preliminary auxiliary layer 210a2 may have the same etching selectivity.

As described above in FIG. 7C, in one or more other embodiments, the photoresist PR may not overlap the second main pixel electrode 210Gm. In such embodiments, the fourth auxiliary layer 210G4 may not be formed on the second main pixel electrode 210Gm from the beginning. For example, both embodiments described above may have a structure in which the fourth auxiliary layer 210G4 is not arranged on the second main pixel electrode 210Gm after the second etching process.

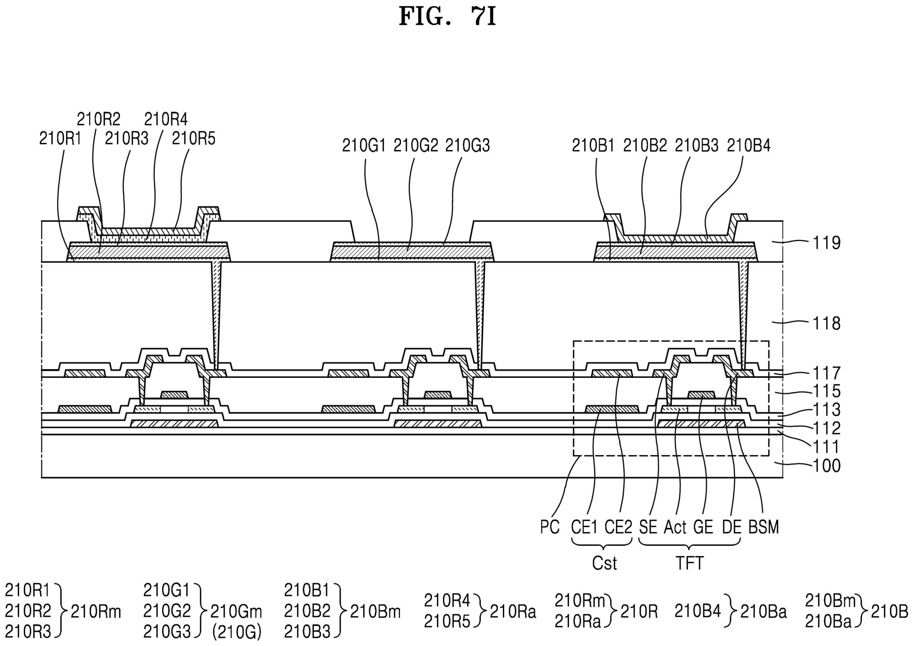

Next, referring to FIG. 7I, the remaining photoresist PR may be removed through a strip process. As the photoresist PR is removed, the first auxiliary layer 210R4 and the second auxiliary layer 210R5 may be arranged on the first main pixel electrode 210Rm, the third auxiliary layer 210B4 may be arranged on the third main pixel electrode 210Bm, and no auxiliary layer may be arranged on the second main pixel electrode 210Gm.

In summary, the first pixel electrode 210R may include the first auxiliary pixel electrode 210Ra including the first auxiliary layer 210R4 and the second auxiliary layer 210R5 in addition to the first main pixel electrode 210Rm. The second pixel electrode 210G may include only the second main pixel electrode 210Gm without an auxiliary pixel electrode. The third pixel electrode 210B may include the second auxiliary pixel electrode 210Ba including the third auxiliary layer 210B4 in addition to the third main pixel electrode 210Bm.

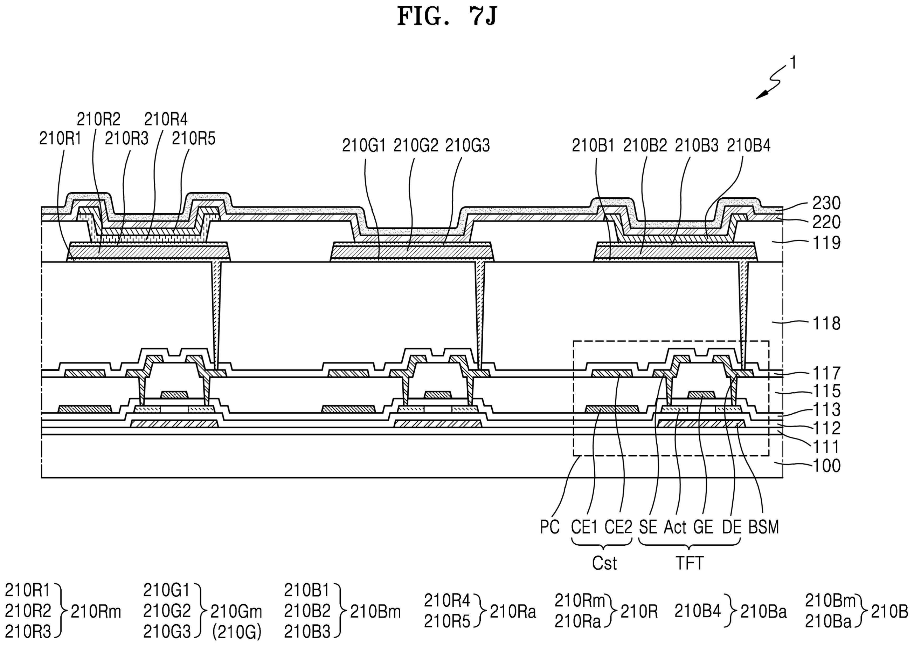

Next, referring to FIG. 7J, an intermediate layer 220 and an opposite electrode 230 may be sequentially formed on the first pixel electrode 210R, the second pixel electrode 210G, and the third pixel electrode 210B. The emission layer of the intermediate layer 220 may be formed by a thermal evaporation or inkjet printing process, and the opposite electrode 230 may be formed by a sputtering or thermal evaporation process.

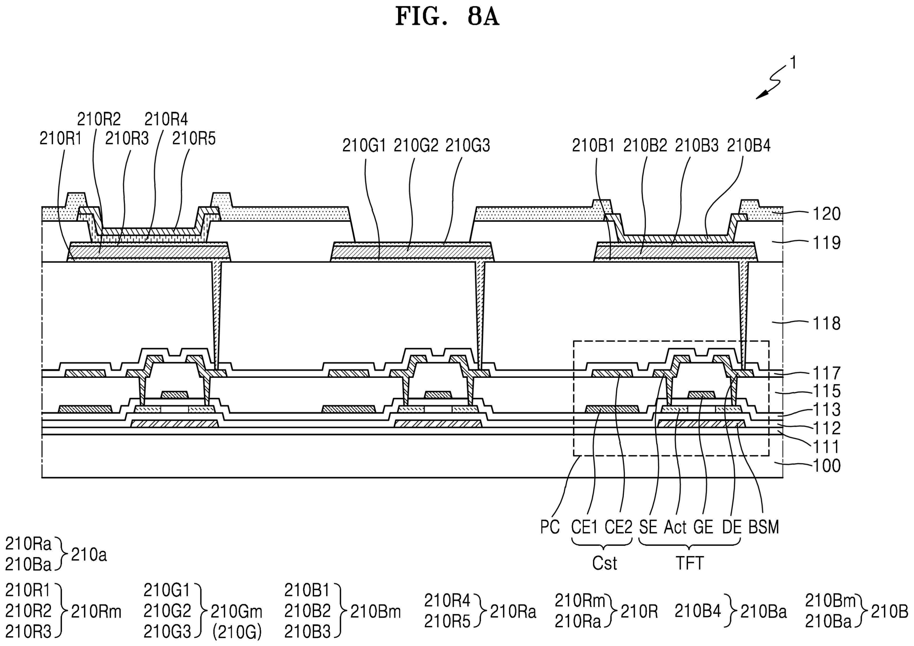

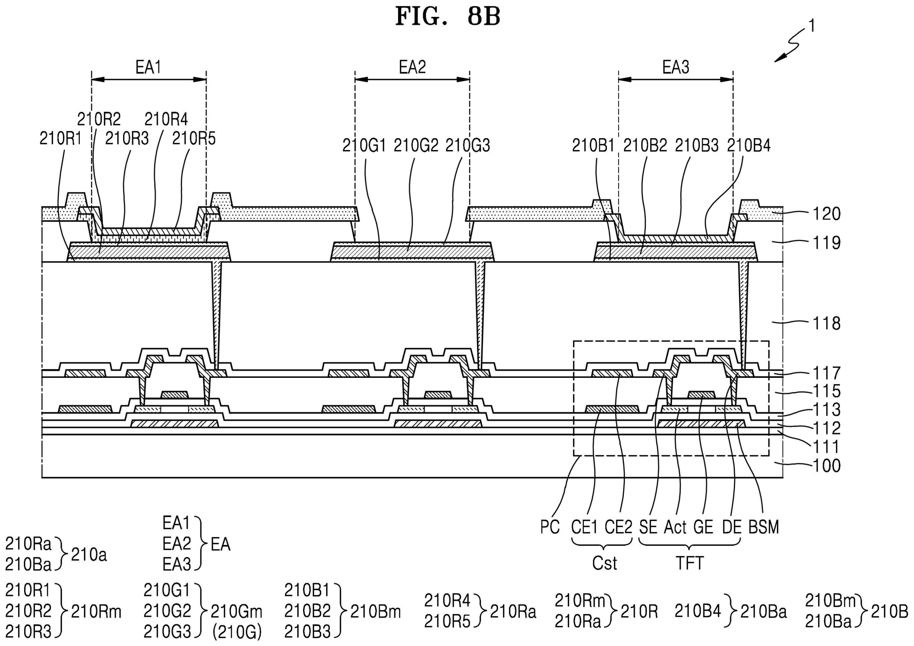

FIG. 8A is a schematic cross-sectional view of a portion of a display apparatus according to one or more embodiments of the present disclosure. FIG. 8B is a schematic cross-sectional view of a portion of a display apparatus according to one or more embodiments of the present disclosure. Referring to FIG. 8A and FIG. 8B, except for the feature of a second bank layer 120, the other features may each independently be the same as those described with reference to FIGS. 6 and 7A to 7J. In FIG. 8A and FIG. 8B, the same reference numerals as those in FIGS. 6 and 7A to 7J denote substantially the same members as those in FIGS. 6 to 7J, and thus, the differences therebetween will be mainly described in more detail.

Referring to FIG. 8A and FIG. 8B, the second bank layer 120 may be additionally arranged on the first bank layer 119. The second bank layer 120 may cover the end of the auxiliary pixel electrode 210a. For example, the second bank layer 120 may clad the edges of the first auxiliary pixel electrode 210Ra and the second auxiliary pixel electrode 210Ba. In one or more embodiments, similar to the first bank layer 119, the second bank layer 120 may include one or more organic insulating materials selected from the group consisting of polyimide, polyamide, acrylic resin, benzocyclobutene resin, and phenol resin, and may be formed by a method such as spin coating. In one or more embodiments, the second bank layer 120 may further include a light-absorbing material for blocking light. For example, in one or more embodiments, the second bank layer 120 may further include carbon black and/or a black pigment.

In one or more embodiments, as shown in FIG. 8A, the second bank layer 120 may be arranged on the first bank layer 119, but a width of the second bank layer 120 may be less than a width of the first bank layer 119 in a plan view. For example, as shown in FIG. 8A, the first bank layer 119 may be formed to protrude more than the second bank layer 120 toward an emission area EA, the emission area EA being shown in FIG. 8B.

However, embodiments of the disclosure are not limited thereto, for example, in one or more embodiments, as shown in FIG. 8B, the second bank layer 120 may be arranged on the first bank layer 119, but the width of the second bank layer 120 may be greater than the width of the first bank layer 119 in a plan view. For example, as shown in FIG. 8B, a lower surface of the second bank layer 120 may be formed to protrude more than an upper surface of the first bank layer 119 toward the emission area EA. In these embodiments, an area of the emission area EA may be adjusted depending on how much the second bank layer 120 protrudes beyond the first bank layer 119. For example, in order to improve or optimize the emission area EA, the width of the second bank layer 120 may be freely adjusted.

In summary, the display apparatus 1 according to one or more embodiments may solve and address problems, such as short circuits, burns, and shorts that may occur due to the auxiliary pixel electrode 210a in a subsequent process, by additionally including the second bank layer 120 that clads the end of the auxiliary pixel electrode 210a. For example, the display apparatus 1 according to one or more embodiments may concurrently (e.g., simultaneously) improve light extraction efficiency and reliability by including the auxiliary pixel electrode 210a and the second bank layer 120.

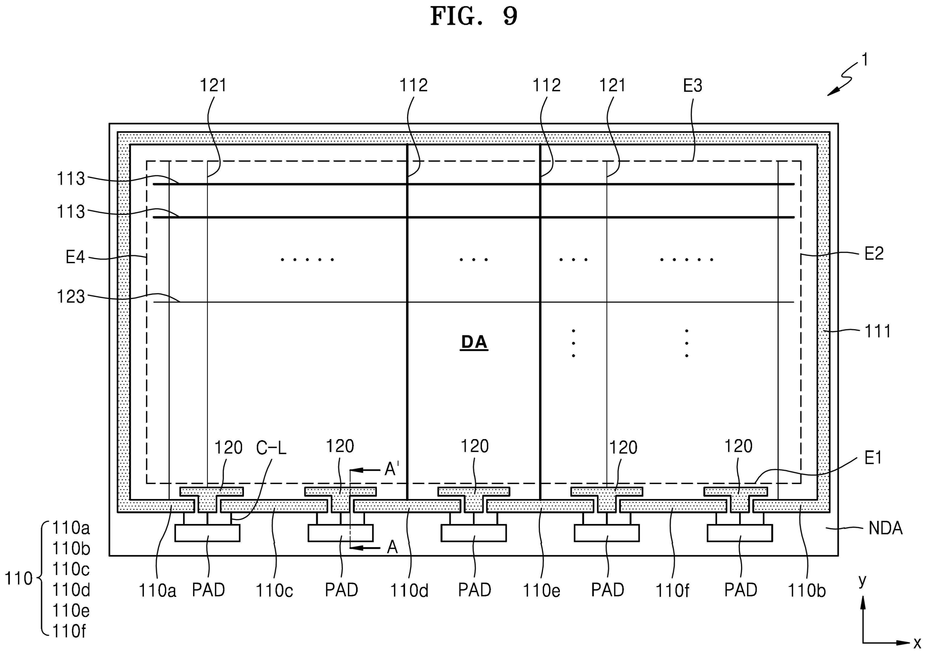

FIG. 9 is a schematic plan view of a display apparatus according to one or more embodiments of the present disclosure.

Referring to FIG. 9, a display apparatus 1 may include a display area DA in which a plurality of pixels are arranged and a non-display area NDA outside the display area DA. The non-display area NDA is an area that does not provide an image, and a driver or voltage wiring lines for providing an electrical signal or power to the pixel circuits PC (see FIG. 3) may be arranged in the non-display area NDA. In addition, the non-display area NDA may include a pad PAD, which is an area to which an electronic component or a printed circuit board may be electrically connected.

A common voltage input portion 110, a driving voltage input portion 120, and the pad PAD may be located in the non-display area NDA adjacent to a first edge E1 of the display area DA.

A plurality of common voltage input portions 110 may be provided along a first edge E1 of the display area DA. In relation to this, FIG. 9 illustrates that a first common voltage input portion 110a and a second common voltage input portion 110b are respectively arranged at two opposite ends of the first edge E1 of the display area DA and third to sixth common voltage input portions 110c, ..., and 110f are spaced and/or apart (e.g., spaced apart or separated) from each other along the first edge E1.

The first common voltage input portion 110a and the second common voltage input portion 110b may be connected to each other by a main common voltage line 111 extending along a second edge E2, a third edge E3, and a fourth edge E4 of the display area DA. For example, in one or more embodiments, the first common voltage input portion 110a, the second common voltage input portion 110b, and the main common voltage line 111 may be integrally formed as a single body.

The common voltage input portions 110 and the main common voltage line 111 may be electrically connected to the opposite electrode 230 (see FIG. 5) of the light-emitting diode LED (see FIG. 5). For example, the opposite electrode 230 (see FIG. 5) of the light-emitting diode LED (see FIG. 5) may entirely cover the display area DA and may extend to the non-display area NDA to directly contact the common voltage input portions 110 and a portion of the main common voltage line 111.

In the display area DA, vertical common voltage lines 112 and horizontal common voltage lines 113 that are electrically connected to the common voltage input portion 110 and the main common voltage line 111 may be arranged. The vertical common voltage lines 112 may electrically connect the common voltage input portion 110 to the main common voltage line 111 across the display area DA in a second direction (e.g., the y direction). The horizontal common voltage lines 113 may extend in a first direction (e.g., the x direction) in the display area DA and be electrically connected to the vertical common voltage lines 112. When the area of the display area DA is relatively large, the opposite electrode 230 (see FIG. 5) of the light-emitting diode LED (see FIG. 5) may cause a voltage drop in each part within the display area DA. For example, because a central portion of the display area DA is located far from the common voltage input portions 110 and the main common voltage line 111, a voltage drop due to the resistance of the opposite electrode 230 (see FIG. 5) itself may be caused, which may deteriorate the display quality. The vertical common voltage line 112 and the horizontal common voltage line 113 crossing the display area DA may be connected to the opposite electrode 230 (see FIG. 5) of the light-emitting diode LED (see FIG. 5) in the display area DA, thereby preventing or reducing the aforementioned voltage drop.

A plurality of driving voltage input portions 120 may be provided along the first edge E1 of the display area DA. As shown in FIG. 9, each of the driving voltage input portions 120 may be arranged between the common voltage input portions 110 spaced and/or apart from each other. Pads PAD may be arranged to correspond to the driving voltage input portions 120. For example, one driving voltage input portion 120 and common voltage input portions 110 arranged on both (e.g., simultaneously) sides (e.g., opposite sides) with the driving voltage input portion 120 therebetween may be connected to one pad PAD through a connection line C-L.

The driving voltage input portion 120 may be electrically connected to a vertical driving voltage line 121 that crosses the display area DA in the second direction (e.g., the y direction), and a horizontal driving voltage line 123 that crosses the display area DA in the first direction (e.g., the x direction). When the area of the display area DA is relatively large, the vertical driving voltage line 121 may cause a voltage drop in each part within the display area DA. For example, a portion adjacent to the third edge E3 of the display area DA may be located far from the driving voltage input portion 120, and thus a voltage drop may be caused by the resistance of the vertical driving voltage line 121 itself. Therefore, the horizontal driving voltage lines 123 crossing the display area DA in the first direction (e.g., the x direction) may be connected to the vertical driving voltage lines 121, thereby preventing or reducing the voltage drop described above.

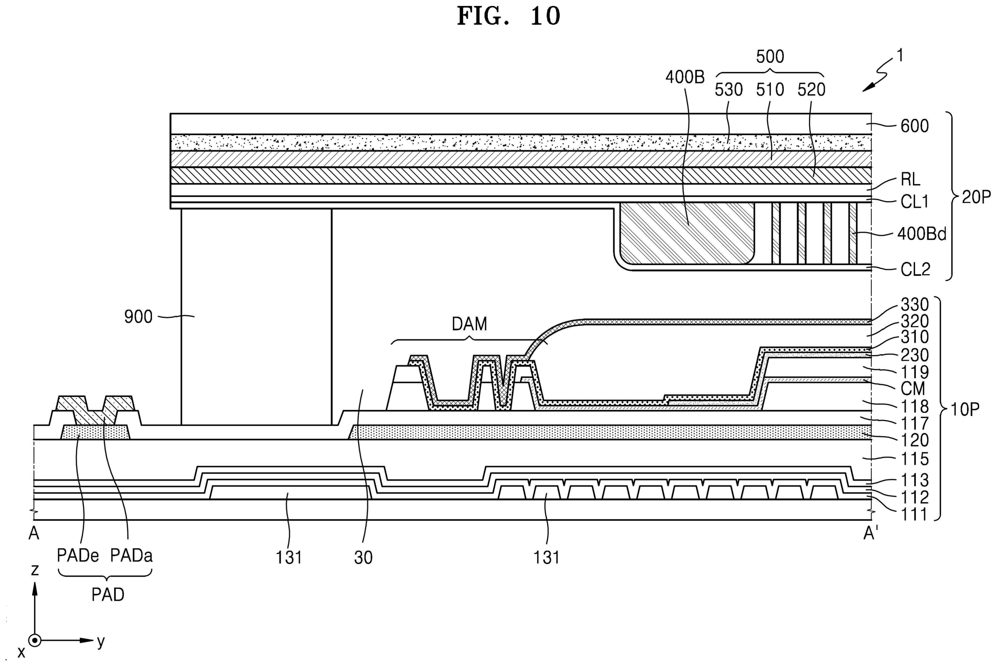

FIG. 10 is a cross-sectional view of the display apparatus 1 taken along the line A-A' in FIG. 9 according to one or more embodiments of the present disclosure.

Referring to FIG. 10 in conjunction with FIG. 9, the display apparatus 1 may include a dam portion DAM arranged on an edge of a first substrate 100. The dam portion DAM may be arranged on the periphery of the display area DA to define the boundary of an organic encapsulation layer 320 if (e.g., when) the organic encapsulation layer 320 is formed. In this regard, at least one dam portion DAM may be provided. For example, in one or more embodiments, a plurality of dam portions DAM may be provided to be spaced and/or apart (e.g., spaced apart or separated) from each other from an end of the first substrate 100.

The dam portion DAM may include an insulating layer. For example, in one or more embodiments, the dam portion DAM may include a same layer as at least one of a planarization layer 118 or a first bank layer 119. In addition, the dam portion DAM may also include a wiring protection layer 117. In one or more embodiments, the dam portion DAM may further include a same layer as a spacer arranged on the first bank layer 119. In the embodiments described above, if (e.g., when) the dam portion DAM includes a plurality of layers, a height of one of the plurality of dam portions DAM may be different from a height of another one of the plurality of dam portions DAM. For example, in one or more embodiments, the height of a dam portion DAM closer to the end of the first substrate 100 from among the plurality of dam portions DAM may be greater than the height of another one of the plurality of dam portions DAM.

In one or more embodiments, an upper surface of at least one selected from among the dams forming the dam portion DAM may be in direct contact with a first inorganic encapsulation layer 310 or a second inorganic encapsulation layer 330. In one or more embodiments, in a plan view, the upper surface of at least one selected from among the dams forming the dam portion DAM may not overlap the organic encapsulation layer 320. In addition, the first inorganic encapsulation layer 310 and the second inorganic encapsulation layer 330 may be in direct contact with each other on an upper portion of at least one selected from among the dams forming the dam portion DAM. For example, the first inorganic encapsulation layer 310 and the second inorganic encapsulation layer 330 may form an inorganic contact area, and thus may block or reduce moisture and impurities from penetrating from the outer edge of the display apparatus 1 to display elements arranged in the display area DA (see FIG. 9).

The display apparatus 1 may include a plurality of signal wiring lines 131 arranged between the first substrate 100 and a first buffer layer 111. In this regard, the plurality of signal wiring lines 131 may include fan-out lines. In one or more embodiments, the plurality of signal wiring lines 131 may be arranged between the first buffer layer 111 and a second buffer layer 112 in addition to the above-described position. In one or more embodiments, some of the plurality of signal wiring lines 131 may be arranged between the first buffer layer 111 and the first substrate 100, and some others of the plurality of signal wiring lines 131 may be arranged between the first buffer layer 111 and the second buffer layer 112.

As described in FIG. 9, the display apparatus 1 may include a driving voltage input portion 120. The driving voltage input portion 120 may be arranged on an interlayer insulating layer 115. For example, in one or more embodiments, the driving voltage input portion 120 may be arranged on a same layer as the source electrode SE (see FIG. 5) and/or the drain electrode DE (see FIG. 5) of the display area DA (see FIG. 9). In one or more embodiments, the common voltage input portion 110 (see FIG. 9) may be arranged on a same layer as the driving voltage input portion 120. The common voltage input portion 110 (see FIG. 9) may extend within the non-display area NDA (see FIG. 9), and the display apparatus 1 may include a connection wiring line CM connected to the common voltage input portion 110 (see FIG. 9). In this regard, the connection wiring line CM may be connected to the common voltage input portion 110 (see FIG. 9), and an extending portion of an opposite electrode 230 may be arranged above the connection wiring line CM.

An upper panel 20P may include a color filter layer 500 extending to the non-display area NDA. The color filter layer 500 may include a first color filter 510, a second color filter 520, and a third color filter 530 that are stacked in the non-display area NDA. Because a plurality of color filters, that is, the first to third color filters 510, 520, and 530, overlap one another, light emitted from the lower panel 10P may not pass through the color filter layer 500. Accordingly, the non-display area NDA may be an area that is not visible, for example, no light is emitted from the non-display area NDA.

On the color filter layer 500, in addition to a refractive layer RL, at least one of a first capping layer CL1 or a second capping layer CL2 on the refractive layer RL may be arranged. For example, at least one of the first capping layer CL1 or the second capping layer CL2 may be arranged to extend from a portion of a second substrate 600 corresponding to the display area DA (see FIG. 9) of the lower panel 10P to an end of the second substrate 600, thereby shielding one side of the refractive layer RL.

An upper bank layer 400B may be arranged between the first capping layer CL1 and the second capping layer CL2. The upper bank layer 400B may be arranged to overlap a portion of the non-display area NDA (see FIG. 9) from the display area DA (see FIG. 9). The upper bank layer 400B may include a dummy upper bank layer 400Bd arranged in the non-display area NDA (see FIG. 9). In one or more embodiments, the dummy upper bank layer 400Bd may have additional openings that do not overlap the light-emitting elements in a plan view. A functional layer 400 (see FIG. 5) may be arranged in a plurality of openings of the dummy upper bank layer 400Bd. For example, in one or more embodiments, a transmissive portion 430 (see FIG. 5) may be arranged in the plurality of openings of the dummy upper bank layer 400Bd.

A sealing member 900 may couple the first substrate 100 to the second substrate 600. For example, in one or more embodiments the sealing member 900 may be arranged between the lower panel 10P and the upper panel 20P. The sealing member 900 may be arranged in the non-display area NDA (see FIG. 9) to surround an outer area of the display area DA (see FIG. 9). For example, in one or more embodiments, the sealing member 900 may have a shape of a hollow rectangle (e.g., square) in a plan view. However, the shape of the sealing member 900 is not limited thereto. If (e.g., when) the first substrate 100 and the second substrate 600 have one or more suitable plane shapes, such as a triangle, a rhombus, a polygon, a circle, or an oval, the sealing member 900 may have a plane shape, such as a hollow triangle, a hollow rhombus, a hollow polygon, a hollow circle, or a hollow oval. In one or more embodiments, the sealing member 900 may include an organic material. For example, in one or more embodiments, the sealing member 900 may include an epoxy resin. In one or more embodiments, the sealing member 900 may be applied in the form of a frit including glass, and/or the like.

In one or more embodiments, a filling layer 30 including a filler may be placed in a space between the lower panel 10P and the upper panel 20P surrounded by the sealing member 900. The filling layer 30 may fill the space between the lower panel 10P and the upper panel 20P. The filler included in the filling layer 30 may include a material that may be to transmit light. For example, the filler may include an organic material including a silicon-based organic material, an epoxy-based organic material, or a mixture of a silicon-based organic material and an epoxy-based organic material.

As described above (see FIG. 9), the display apparatus 1 may further include a pad PAD. The pad PAD may include a pad electrode PADe that may be exposed to the outside. The pad PAD may be arranged further outside of the lower panel 10P than the sealing member 900. A flexible circuit board, and/or the like arranged externally may be connected to the pad PAD. In addition, the pad PAD may be connected to the driving voltage input portion 120, the plurality of signal wiring lines 131, and/or the like. In this regard, the pad PAD may include a plurality of terminals.

In one or more embodiments, the pad PAD may further include a pad auxiliary layer PADa arranged on the pad electrode PADe. The pad auxiliary layer PADa is a layer for protecting the pad electrode PADe that may be exposed to the outside, and by arranging the pad auxiliary layer PADa, a pad robust structure may be formed. In one or more embodiments, the pad auxiliary layer PADa may include a same material as at least some selected from among the sub-layers included in the auxiliary pixel electrode 210a (see FIG. 6). For example, in one or more embodiments, the pad auxiliary layer PADa may be formed through a same process as the second auxiliary layer 210R5 (see FIG. 6) and the third auxiliary layer 210B4 (see FIG. 6), and may include a same material as the second auxiliary layer 210R5 (see FIG. 6) and the third auxiliary layer 210B4 (see FIG. 6).

In summary, in the display apparatus 1 according to one or more embodiments, the auxiliary pixel electrode 210a may be formed using a TCO material in the display area DA (see FIG. 9) and the pad auxiliary layer PADa may be formed using a TCO material in the non-display area NDA (see FIG. 9), and thus, the light extraction efficiency and reliability of the display apparatus 1 may be concurrently (e.g., simultaneously) improved.

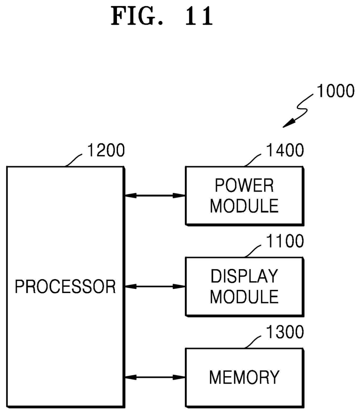

FIG. 11 is a block diagram of an electronic apparatus 1000 according to one or more embodiments of the present disclosure.

Referring to FIG. 11, the electronic apparatus 1000 according to one or more embodiments may include a display module 1100, a processor 1200, a memory 1300, and a power module 1400.

The electronic apparatus 1000 may output one or more suitable pieces of information through the display module 1100 within an operating system.

The processor 1200 may include at least one of a central processing unit (CPU), an application processor (AP), a graphic processing unit (GPU), a communication processor (CP), an image signal processor (ISP), or a controller. In one or more embodiments, the processor 1200 may be provided by being functionally or structurally divided into two or more processors. For example, the processor 1200 may include a main processor in the form of a first driving chip including a CPU, and an auxiliary processor in the form of a second driving chip including a controller configured to receive an image signal from the main processor and process the image signal to be adapted to an interface specification of the display module 1100.

The memory 1300 may include at least one of a non-volatile memory or a volatile memory. The memory 1300 may store data information desired or required for an operation of the processor 1200 and/or the display module 1100. When the processor 1200 executes an application stored in the memory 1300, an image data signal and/or an input control signal may be transmitted to the display module 1100, and the display module 1100 may process the provided signal, and thus, may output image information via a display screen.

The power module 1400 may include a power supply module such as a power adaptor or a battery device, and a power conversion module for generating, by converting power supplied by the power supply module, power desired or required for an operation of the electronic apparatus 1000. Power conversion by the power conversion module may include, but is not limited to, direct current (DC)-DC conversion, alternating current (AC)-DC conversion, and DC-AC conversion.

At least one selected from among the components of the electronic apparatus 1000 described above may be included in the display apparatus according to the embodiments described above. In addition, some of individual modules functionally included in one module may be included in the display apparatus, and others may be provided separately from the display apparatus. For example, in one or more embodiments, the display apparatus may include the display module 1100 and an auxiliary processor of the processor 1200, and a main processor of the processor 1200, the memory 1300, and the power module 1400 may be provided in the form of other devices in the electronic apparatus 1000 other than the display apparatus. In one or more embodiments, the power module 1400 may be arranged in the display apparatus and may supply power to the processor 1200 and the memory 1300 arranged in the electronic apparatus 1000 other than the display apparatus. However, embodiments of the present disclosure are not limited thereto.

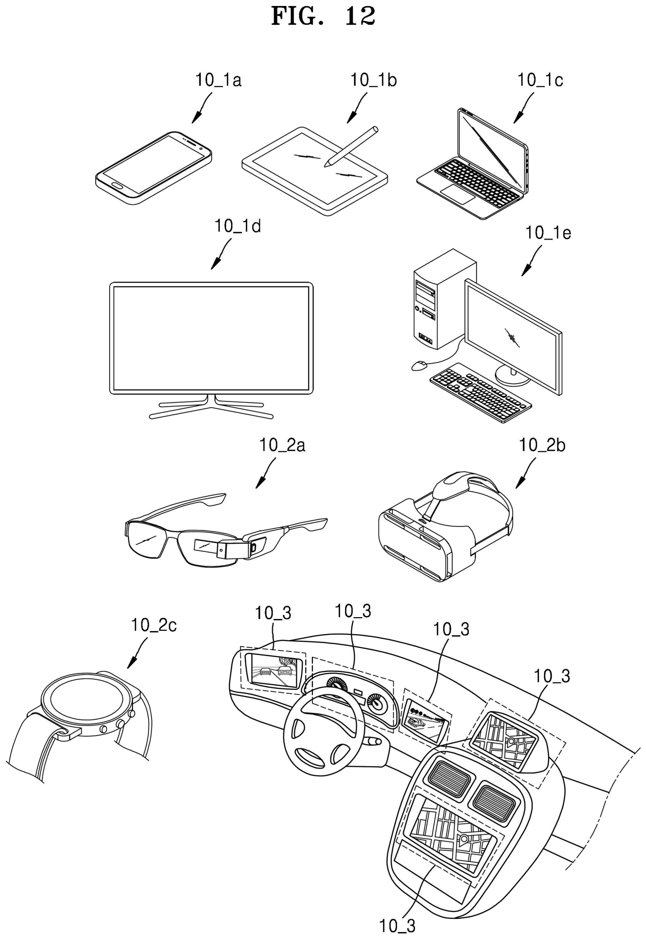

FIG. 12 is a schematic diagram illustrating various electronic apparatuses according to one or more embodiments of the present disclosure.

The display apparatus according to one or more embodiments is a device that displays a moving image or a still image, and may be applied to one or more suitable electronic apparatuses. Referring to FIG. 12, one or more suitable electronic apparatuses to which the display apparatus according to one or more embodiments is applied may include not only an image display electronic apparatus, such as a smartphone 10_1a, a tablet PC 10_1b, a laptop 10_1c, a television (TV) 10_1d, or a desk monitor 10_1e, but also a wearable electronic apparatus including a display module, such as smart glasses 10_2a, a head mounted display 10_2b, or a smart watch 10_2c, and a vehicle electronic apparatus 10_3 including a display module, such as a Center Information Display (CID) or a room mirror display, placed on a panel, center fascia, or dashboard of a car. However, the electronic apparatus 1000 according to one or more embodiments is not limited to the aforementioned devices.

The electronic apparatuses of FIG. 12 may include the components illustrated in FIG. 11. For example, the smartphone 10_1a may include the display module 1100, the processor 1200, the memory 1300, and the power module 1400, illustrated in FIG. 11. The smartphone 10_1a may further include a communication module and a battery device. Power provided from the battery device may be converted through the power module 1400 and provided to the processor 1200, the memory 1300, and the display module 1100. In one or more embodiments, a display apparatus applied to the smartphone 10_1a may include the display module 1100 and further include the power module 1400. The processor 1200 and the memory 1300 may be provided in the form of chips mounted on a motherboard, which is an external device, but embodiments of the present disclosure are not limited thereto.

According to one or more embodiments of the present disclosure, a display apparatus having improved display quality and reliability and an electronic apparatus including the display apparatus may be provided. The aforementioned effects are example, and the effect of the disclosure is not limited thereto.

In the context of the present application and unless otherwise defined, the terms "use," "using," and "used" may be considered synonymous with the terms "utilize," "utilizing," and "utilized," respectively.

Spatially relative terms, such as "beneath," "below," "lower," "above," "upper," and/or the like, may be used herein for descriptive purposes, and, thereby, to describe one element or feature's relationship to another element(s) or feature(s) as shown in the drawings. Spatially relative terms are intended to encompass different orientations of a device in use, operation, and/or manufacture in addition to the orientation depicted in the drawings. For example, if (e.g., when) the device in the drawings is turned upside down, elements described as "below" or "beneath" other elements or features would then be oriented "above" or "on" the other elements or features. Thus, in one or more embodiments, the example term "below" may encompass both (e.g., simultaneously) an orientation of above and below directions. Furthermore, the device may be otherwise oriented (e.g., rotated 90 degrees or at other orientations), and, as such, the spatially relative descriptors used herein interpreted accordingly.

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, ± 20%, ± 10%, or ± 5% of the stated value. Also, it should be understood that, even if the terms "about," "approximately," or "substantially" are not expressly recited in a given element (e.g., a claim element), the scope of such element is intended to include variations that are insubstantial or within the understanding of one of ordinary skill in the art. For example, numerical values and ranges provided herein are intended to include tolerances and measurement uncertainties that would be recognized by those skilled in the art, and the elements (e.g., claim elements) should be construed accordingly to encompass such equivalents.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

The display apparatus, the display module, the electronic apparatus, the display apparatus-manufacturing apparatus, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random-access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made therein without departing from the scope as defined by the following claims and equivalents thereof.

## Claims

1. A display apparatus (1), comprising:
a substrate (100) comprising a display area (DA) and a non-display area (NDA) around the display area (DA);
a first pixel circuit (PC1) on the display area (DA) of the substrate (100);
a first main pixel electrode (210Rm) on the first pixel circuit (PC1) and electrically connected to the first pixel circuit (PC1);
a first bank layer (119) covering an end of the first main pixel electrode (210Rm) and having a first opening (OP1) overlapping a portion of the first main pixel electrode (210Rm);
a first auxiliary pixel electrode (210Ra) on the first bank layer (119) and the first main pixel electrode (210Rm);
an intermediate layer (220) on the first auxiliary pixel electrode (210Ra); and
an opposite electrode (230) on the intermediate layer (220).

2. The display apparatus (1) of claim 1, wherein the first main pixel electrode (210Rm) comprises:
a first sub-layer (210R1) comprising a transparent conductive oxide;
a second sub-layer (210R2) on the first sub-layer (210R1) and comprising at least one selected from the group consisting of Ag, Al, Mg, Li, Ca, Cu, LiF/Ca, LiF/Al, MgAg, and CaAg; and
a third sub-layer (210R3) on the second sub-layer (210R2) and comprising a transparent conductive oxide.

3. The display apparatus (1) of claim 1 or claim 2, wherein the first auxiliary pixel electrode (210Ra) comprises:
a first auxiliary layer (210R4) comprising a transparent conductive oxide; and
a second auxiliary layer (210R5) on the first auxiliary layer (210R4) and comprising a transparent conductive oxide.

4. The display apparatus (1) of any one of claims 1 to 3, further comprising a second main pixel electrode (210Gm) on a same layer as the first main pixel electrode (210Rm) and spaced from the first main pixel electrode (210Rm),
wherein the first bank layer (119) covers an end of the second main pixel electrode (210Gm) and further has a second opening (OP2) overlapping a portion of the second main pixel electrode (210Gm), and the intermediate layer (220) is in direct contact with the second main pixel electrode (210Gm) within the second opening (OP2).

5. The display apparatus (1) of claim 4, further comprising:
a first color conversion portion (410) on the opposite electrode (230) and overlapping the first opening (OP1) in a plan view; and
a second color conversion portion (420) on the opposite electrode (230) and overlapping the second opening (OP2) in a plan view,
wherein the first color conversion portion (410) is configured to convert light emitted from the intermediate layer (220) into light of a first color, and the second color conversion portion (420) is configured to convert the light emitted from the intermediate layer (220) into light of a second color.

6. The display apparatus (1) of any one of claim 1, further comprising:
a third main pixel electrode (210Bm) on a same layer as the first main pixel electrode (210Rm) and spaced from the first main pixel electrode (210Rm); and
a second auxiliary pixel electrode (210Ba) on the first bank layer (119) and the third main pixel electrode (210Bm),
wherein the first bank layer (119) covers an end of the third main pixel electrode (210Bm) and further has a third opening (OP3) overlapping a portion of the third main pixel electrode (210Bm), and relative to a thickness direction of the substrate (100), a thickness of the first auxiliary pixel electrode (210Ra) is greater than a thickness of the second auxiliary pixel electrode (210Ba), optionally further comprising:
a first color conversion portion (410) on the opposite electrode (230) and overlapping the first opening (OP1) in a plan view; and
a transmissive portion (430) on the opposite electrode (230) and overlapping the third opening (OP3) in a plan view,
wherein the first color conversion portion (410) is configured to convert light emitted from the intermediate layer (220) into light of a first color, and the transmissive portion (430) is configured to directly transmit the light emitted from the intermediate layer (220).

7. The display apparatus (1) of any one of claims 1 to 6, further comprising a second bank layer (120) on the first auxiliary pixel electrode (210Ra) and the first bank layer (119) and below the intermediate layer (220),
wherein the second bank layer (120) covers an end of the first auxiliary pixel electrode (210Ra), optionally wherein a lower surface of the second bank layer (120) protrudes further toward the first opening (OP1) than an upper surface of the first bank layer (119).

8. The display apparatus (1) of any one of claims 1 to 7, further comprising:
a pad electrode (PADe) on the non-display area (NDA) of the substrate (100); and
a pad auxiliary layer (PADa) on the pad electrode (PADe),
wherein the pad auxiliary layer (PADa) and at least some selected from among sub-layers included in the first auxiliary pixel electrode (210Ra) comprise a same material.

9. A method of manufacturing a display apparatus (1), comprising:
forming, on a substrate (100), a circuit layer (PCL) comprising a first pixel circuit (PC1), a second pixel circuit (PC2), and a third pixel circuit (PC3);
forming a planarization layer (118) covering the first pixel circuit (PC1), the second pixel circuit (PC2), and the third pixel circuit (PC3);
forming, on the planarization layer (118), a plurality of main pixel electrodes (210Rm, 210Gm, 210Bm) comprising a first main pixel electrode (210Rm) electrically connected to the first pixel circuit (PC1), a second main pixel electrode (210Gm) electrically connected to the second pixel circuit (PC2), and a third main pixel electrode (210Bm) electrically connected to the third pixel circuit (PC3);
forming a first bank layer (119) arranged on the planarization layer (118), covering an end of each of the plurality of main pixel electrodes (210Rm, 210Gm, 210Bm), and comprising a plurality of openings (OP1, OP2, OP3) exposing an upper surface of each of the plurality of main pixel electrodes (210Rm, 210Gm, 210Bm);
forming a plurality of auxiliary pixel electrodes (210Ra, 210Ba) arranged on the first bank layer (119) and comprising a first auxiliary pixel electrode (210Ra) arranged on the first main pixel electrode (210Rm) and a second auxiliary pixel electrode (210Ba) arranged on the third main pixel electrode (210Bm);
forming an intermediate layer (220) on the first bank layer (119) and the plurality of main pixel electrodes (210Rm, 210Gm, 210Bm); and
forming an opposite electrode (230) on the intermediate layer (220).

10. The method of claim 9, wherein the forming of the plurality of auxiliary pixel electrodes (210Ra, 210Ba) comprises:
forming a first auxiliary layer (210R4) of the first auxiliary pixel electrode (210Ra) arranged on the first main pixel electrode (210Rm); and
forming a second auxiliary layer (210R5) of the first auxiliary pixel electrode (210Ra) arranged on the first auxiliary layer (210R4), and a third auxiliary layer (210B4) of the second auxiliary pixel electrode (210Ba) arranged on the third main pixel electrode (210Bm).

11. The method of claim 10, wherein the forming of the first auxiliary layer (210R4) of the first auxiliary pixel electrode (210Ra) comprises:
depositing, on an entire surface of the substrate (100), a first preliminary auxiliary layer (210a1) arranged on the plurality of main pixel electrodes (210Rm, 210Gm, 210Bm) and the first bank layer (119);
forming, on the first preliminary auxiliary layer (210a1), a photoresist (PR) overlapping the first main pixel electrode (210Rm) in a plan view;
etching a portion of the first preliminary auxiliary layer (210a1) that does not overlap the photoresist (PR); and
stripping the photoresist (PR), optionally wherein the etching of the portion of the first preliminary auxiliary layer (210a1) is performed through a wet etch process, and the plurality of main pixel electrodes (210Rm, 210Gm, 210Bm) are not etched through the wet etch process, and
further optionally wherein the forming of the first bank layer (119) further comprises hardening the first bank layer (119) through a curing process,
wherein a material included in the first preliminary auxiliary layer (210a1) and a material included in each of the plurality of main pixel electrodes (210Rm, 210Gm, 210Bm) after the curing process have different etching selectivities.

12. The method of claim 10 or claim 11, wherein:
(i) the forming of the second auxiliary layer (210R5) of the first auxiliary pixel electrode (210Ra) and the third auxiliary layer (210B4) of the second auxiliary pixel electrode (210Ba) comprises:
depositing, on an entire surface of the substrate, a second preliminary auxiliary layer (210a2) arranged on the first auxiliary layer (210R4);
forming, on the second preliminary auxiliary layer (210a2), a photoresist (PR) overlapping the first main pixel electrode (210Rm) and the third main pixel electrode (210Bm) in a plan view;
etching a portion of the second preliminary auxiliary layer (210a2) that does not overlap the photoresist (PR); and
stripping the photoresist (PR), and
optionally wherein the etching of the portion of the second preliminary auxiliary layer (210a2) is performed through a wet etch process, and the plurality of main pixel electrodes (210Rm, 210Gm, 210Bm) are not etched through the wet etch process; and/or
(ii) the method further comprises forming a second bank layer (120) arranged between the first bank layer (119) and the intermediate layer (220) and covering an end of each of the plurality of auxiliary pixel electrodes (210Ra, 210Ba).

13. The method of any one of claims 9 to 12, further comprising forming a functional layer (400) on the opposite electrode (230),
wherein the forming of the functional layer (400) comprises:
forming a first color conversion portion (410) overlapping the first main pixel electrode (210Rm) in a plan view and configured to convert light emitted from the intermediate layer (220) into light of a first color;
forming a second color conversion portion (420) overlapping the second main pixel electrode (210Gm) in a plan view and configured to convert light emitted from the intermediate layer (220) into light of a second color; and
forming a transmissive portion (430) overlapping the third main pixel electrode (210Bm) in a plan view and configured to directly transmit light emitted from the intermediate layer (220).

14. An electronic apparatus (1000) comprising:
a display apparatus (1); and
a processor (1200) configured to control the display apparatus (1),
wherein the display apparatus (1) comprises:
a substrate (100) comprising a display area (DA) and a non-display area (NDA) around the display area (DA);
a circuit layer (PCL) comprising a first pixel circuit (PC1), a second pixel circuit (PC2), and a third pixel circuit (PC3) that are each on the display area (DA) of the substrate (100); and
a display element layer (DEL) on the circuit layer (PCL) and comprising a first light-emitting diode (LED1) electrically connected to the first pixel circuit (PC1), a second light-emitting diode (LED2) electrically connected to the second pixel circuit (PC2), and a third light-emitting diode (LED3) electrically connected to the third pixel circuit (PC3),
wherein:
the display element layer (DEL) further comprises a first bank layer (119) defining an emission area (EA1, EA2, EA3) of each of the first light-emitting diode (LED1), the second light-emitting diode (LED2), and the third light-emitting diode (LED3);
each of the first light-emitting diode (LED1), the second light-emitting diode (LED2), and the third light-emitting diode (LED3) comprises a pixel electrode (210R, 210G, 210B), an intermediate layer (22) arranged on the pixel electrode (210R, 210G, 210B); and
an opposite electrode (230) arranged on the intermediate layer (220), and
wherein relative to a thickness direction of the substrate (100), a thickness of the pixel electrode (210R) of the first light-emitting diode (LED1), a thickness of the pixel electrode (210G) of the second light-emitting diode (LED2), and a thickness of the pixel electrode (210B) of the third light-emitting diode (LED3) are different from one another.

15. The electronic apparatus (1000) of claim 14, wherein,
the pixel electrode (210R) of the first light-emitting diode (LED1) comprises a first main pixel electrode (210Rm) and a first auxiliary pixel electrode (210Ra) on the first bank layer (119),
the pixel electrode (210G) of the second light-emitting diode (LED2) comprises a second main pixel electrode (210Gm) that is in direct contact with the intermediate layer (220),
the pixel electrode (210B) of the third light-emitting diode (LED3) comprises a third main pixel electrode (210Bm) and a second auxiliary pixel electrode (210Ba) on the first bank layer (119), and
a thickness of the first auxiliary pixel electrode (210Ra) and a thickness of the second auxiliary pixel electrode (210Ba) are different from each other in the thickness direction of the substrate (100), optionally wherein the first auxiliary pixel electrode (210Ra) comprises a first auxiliary layer (210R4) and a second auxiliary layer (210R5) on the first auxiliary layer (210R4), and
wherein the second auxiliary pixel electrode (210Ba) comprises a third auxiliary layer (210B4) comprising a same material as the second auxiliary layer (210R5).
